# EUROPEAN PATENT APPLICATION

(11) **EP 4 682 881 A2**
(43) Date of publication of application: **21.01.2026**
(21) Application number: 25175630.0
(22) Date of filing: 12.05.2025
(51) Int. Cl.: G11C 11/406

(54) **MEMORY DEVICE, HOST DEVICE, AND MEMORY SYSTEM INCLUDING THEREOF**

(30) Priority: 19.07.2024 KR 20240095546; 23.09.2024 KR 20240128572; 29.10.2024 KR 20240149507
(71) Applicant: Samsung Electronics Co., Ltd., Suwon-si, Gyeonggi-do 16677 (KR)
(72) Inventor: KIM, Chinam, Suwon-si, Gyeonggi-do 16677 (KR); KIM, Kwangsu, Suwon-si, Gyeonggi-do 16677 (KR); KIM, Do-Han, Suwon-si, Gyeonggi-do 16677 (KR); KIM, Dongha, Suwon-si, Gyeonggi-do 16677 (KR); PARK, Youngjae, Suwon-si, Gyeonggi-do 16677 (KR); LEE, Changmin, Suwon-si, Gyeonggi-do 16677 (KR)
(74) Representative: Kuhnen & Wacker Patent- und Rechtsanwaltsbüro PartG mbB

(57) **Abstract**

There is provided a host device (10) communicating with a memory device (100) including a memory bank (140). The host device (10) includes a command issuance circuit (11) configured to issue a regular refresh command for a memory bank (140) of a memory device (100) at every regular refresh period, a first debit counter (12) configured to manage a first debit count (DCNT1) for a first sub-bank (SBNK1) in the memory bank (140), a second debit counter (13) configured to manage a second debit count (DCNT2) for a second sub-bank (SBNK2) in the memory bank (140), and a refresh scheduling circuit (15) configured to determine whether to skip issuing the regular refresh command (REF_REG) of the command issuance circuit (11) based on the first debit count (DCNT1) and the second debit count (DCNT2).

## Description

### BACKGROUND

### 1. Field

The disclosure relates to a semiconductor memory device. More specifically, the disclosure relates to a memory device, a host device controlling the memory device, and a memory system including the memory device and the host device.

### 2. Description of the Related Art

Volatile memory devices such as a dynamic random access memory (DRAM) may store data in a form of charges charged in memory cells. The charges charged in the memory cells of the volatile memory device may leak due to various reasons. Accordingly, the volatile memory device may perform a refresh operation to recharge the charges charged in the memory cells.

Due to recent trends in the volatile memory devices toward higher integration, higher capacity, and higher input/output speeds, a ratio time spent on refresh operations verses the entire operating time of the volatile memory device is gradually increasing. That is, there occurs a problem in which the input/output performance of the volatile memory device is limited by the refresh operation.

### SUMMARY

Aspects of the disclosure provide a memory device skipping a regular refresh operation, a host device controlling the memory device, and a memory system including the host device and the memory device.

According to an aspect of the disclosure, there is provided a host device including: a command issuance circuit configured to issue a regular refresh command for a first memory bank of a memory device at every regular refresh period; a first debit counter configured to manage a first debit count for a first sub-bank in the first memory bank; a second debit counter configured to manage a second debit count for a second sub-bank in the first memory bank; and a refresh scheduling circuit configured to determine whether to skip issuing the regular refresh command of the command issuance circuit based on the first debit count and the second debit count.

For example, the command issuance circuit is further configured to issue a first hidden refresh command for the first sub-bank or a second hidden refresh command for the second sub-bank. For example, the first debit counter is configured to decrease the first debit count based on the command issuance circuit issuing the second hidden refresh command. For example, the second debit counter is configured to decrease the second debit count based on the command issuance circuit issuing the first hidden refresh command.

For example, the first hidden refresh command corresponds to a first row address in a first row address range for the first sub-bank. For example, the second hidden refresh command corresponds to a second row address in a second row address range for the second sub-bank.

For example, a first address range identifier of each row address in the first row address range is a first value. For example, a second address range identifier of each row addresses in the second row address range is a second value, which is different from the first value.

For example, the host device further includes an application processing circuit configured to determine a plurality of pre-shuffle row addresses respectively corresponding to a plurality of data to be stored in the first memory bank. For example, the host device further includes a data distribution circuit configured to generate a plurality of post-shuffle row addresses by respectively converting the plurality of pre-shuffle row addresses. For example, the application processing circuit is configured to store the plurality of data in the first memory bank based on the plurality of post-shuffle row addresses.

According to another aspect of the disclosure, there is provided a memory device including: a memory bank including a first sub-bank and a second sub-bank; a row decoder including a first sub-row decoder connected to the first sub-bank, and a second sub-row decoder connected to the second sub-bank; and a control logic circuit configured to perform, based on a first hidden refresh command corresponding to a first row address of the first sub-bank, a hidden refresh operation for the second sub-bank within a first time period by controlling the second sub-row decoder, wherein a length of the first time period is shorter than a minimum activation period for the memory bank.

For example, the control logic circuit is further configured to perform, based on a regular refresh command for the memory bank, a regular refresh operation for the memory bank during a second time period longer than the first time period by controlling the first and second sub-row decoders.

According to another aspect of the disclosure, there is provided a memory system including: a memory device including a memory bank including a first sub-bank and a second sub-bank; and a host device configured to determine a command to be issued to the memory device based on a first debit count related to the first sub-bank and a second debit count related to the second sub-bank being maintained to be within a debit count range, wherein the first debit count decreases as the first sub-bank is refreshed and increases at regular refresh period, and a second debit count decreases as the second sub-bank is refreshed and increases at the regular refresh period.

For example, the host device is configured to decrease the first debit count by a first value based on a first hidden refresh being performed for the first sub-bank. For example, the host device is configured to decrease the second debit count by the first value based on a second hidden refresh being performed for the second sub-bank. For example, the host device is configured to decrease each of the first and second debit counts by a second value based on a regular refresh for the memory device being performed. For example, the host device is configured to increase each of the first and second debit counts by the second value at the regular refresh period.

### BRIEF DESCRIPTION OF DRAWINGS

FIG. 1 is a block diagram showing a memory system according to an embodiment of the disclosure.
FIG. 2 is a drawing showing the regular refresh operation of the memory system of FIG. 1.
FIG. 3 is a drawing showing a hidden refresh operation of a memory system of FIG. 1.
FIG. 4 is a block diagram showing a memory device of FIG. 1 in more detail.
FIG. 5 is a drawing showing some of components of the memory device of FIG. 4 in more detail.
FIG. 6 is a drawing for illustrating a method of controlling sub-row decoders of FIG. 5.
FIG. 7 is a timing diagram showing an operation of a memory device based on a hidden refresh command that instructs an activation and a hidden refresh operation.
FIG. 8 is a timing diagram showing some of time periods in FIG. 7 in more detail.
FIG. 9 is a timing diagram showing how a debit count of the memory system in FIG. 1 changes based on a regular refresh command and a hidden refresh command according to an embodiment.
FIG. 10 is a flowchart showing an operation method of a host device managing a debit count according to an embodiment of FIG. 9.
FIG. 11 is a flowchart showing an operation method of a host device based on a debit count according to an embodiment of FIG. 9.
FIG. 12 is a drawing showing a regular refresh operation of a memory system of FIG. 1 according to an embodiment.
FIG. 13 is a timing diagram showing how a debit count of the memory system in FIG. 1 changes based on a regular refresh command and a hidden refresh command according to an embodiment of FIG. 12.
FIG. 14 is a flowchart showing an operation method of a host device based on a debit count according to an embodiment of FIG. 13.
FIG. 15 is a graph showing an effect of a hidden refresh according to an embodiment of the disclosure.
FIG. 16 is a timing diagram showing some sections of FIG. 7 in more detail according to an embodiment.
FIG. 17 is a timing diagram showing an operation of a memory device based on a hidden refresh command that instructs read and hidden refresh operations.
FIG. 18 and FIG. 19 are timing diagrams showing an operation of a memory system according to an embodiment.
FIG. 20 is a block diagram showing a configuration of a memory bank according to an embodiment.
FIG. 21 and FIG. 22 are block diagrams showing a configuration of a host device according to an embodiment.
FIG. 23 is a timing diagram showing an implementation of a hidden refresh command according to an embodiment.
FIG. 24 and FIG. 25 are timing diagrams showing an operation method of a memory system according to an embodiment.
FIG. 26 is a timing diagram showing an operation of a memory system of FIG. 1 according to an embodiment.

### DETAILED DESCRIPTION

The present invention will be described more fully hereinafter with reference to the accompanying drawings, in which exemplary embodiments of the invention are shown. Details such as detailed configurations and structures are provided simply to aid in the overall understanding of the embodiments of the disclosure. Moreover, descriptions of well-known functions and structures are omitted for clarity and brevity. The components in the drawings or detailed description below may be connected to other components other than those depicted in the drawings or described in the detailed description. The terms used in the text are terms defined in consideration of the functions of the disclosure and are not limited to specific functions. Definitions of terms may be determined based on the information provided in the detailed description.

Components described with reference to terms such as driver, unit, module or block used in detailed description can be implemented in the form of software, hardware, or a combination thereof. For example, software may be machine code, firmware, embedded code, and application software. For example, hardware may include an electrical circuit, an electronic circuit, a processor, a computer, IC cores, a pressure sensor, an inertial sensor, a Micro Electro Mechanical System (MEMS), passive components, or a combination thereof.

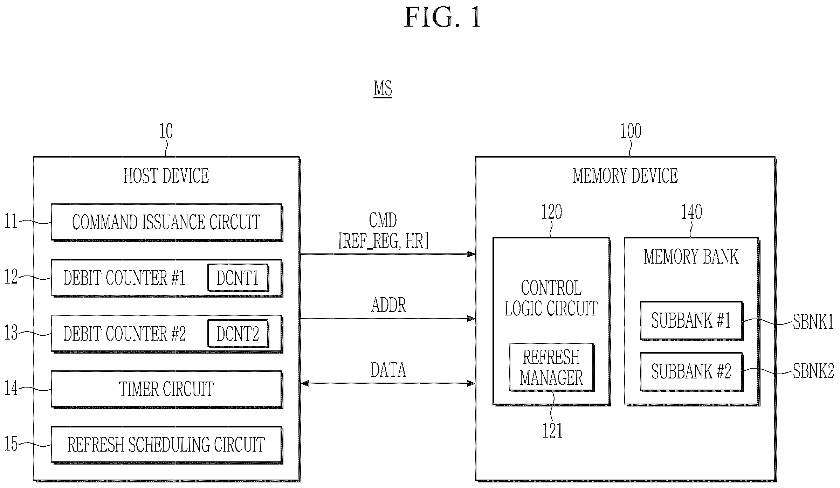

FIG. 1 is a block diagram showing a memory system according to an embodiment of the disclosure. Referring to FIG. 1, a memory system MS may include a host device 10 and a memory device 100.

The host device 10 may control one or more operations of the memory device 100. For example, the host device 10 may control the memory device 100 by issuing various types of command CMD and address ADDR. For example, the host device 10 may issue a read command to read data DATA from the memory device 100, or issue a write command to store data DATA in the memory device 100.

In an embodiment, the host device 10 may issue various types of command CMD and address ADDR in a form of command/address signals C/A.

In an embodiment, the host device 10 may be included in one of various types of processing units. The processing units may include, but is not limited to, a central processing unit (CPU), a graphic processing unit (GPU), and the like.

The memory device 100 may include a control logic 120 and a memory bank 140. However, the disclosure is not limited thereto, and as such, according to an embodiment, the memory device 100 may include one or more other components. The memory bank 140 may include a first sub-bank SBNK1 and a second sub-bank SBNK2. The memory bank 140 store the data DATA. For example, each of the first sub-bank SBNK1 and the second sub-bank SBNK2 may include a plurality of memory cells.

For a more concise explanation, an embodiment in which the memory bank 140 includes the first sub-bank SBNK1 and the second sub-bank SBNK2 will be described as a representative example below. However, the scope of the disclosure is not limited thereto, and the memory bank 140 may include any number of sub-banks. For example, the number of memory banks may be different than two.

Each of the plurality of memory cells included in the memory bank 140 may store data in a form of a charge in a capacitor. However, the amount of charge in each of the plurality of memory cells may change over time, and the data stored in the memory bank 140 may be damaged. Accordingly, the memory device 100 may perform a refresh operation on the plurality of memory cells based on the control of the host device 10, so that the amount of charge stored in each of the plurality of memory cells may be maintained. Hereinafter, a method of performing the refresh operation by the memory device 100 based on the control from the host device 10 will be described.

According to an embodiment, the control logic circuit 120 may control the overall operation of the memory device 100. For example, the control logic circuit 120 may perform the refresh operation for a specific sub-bank SBNK or for all sub-bank SBNKs based on the command CMD provided from the host device 10.

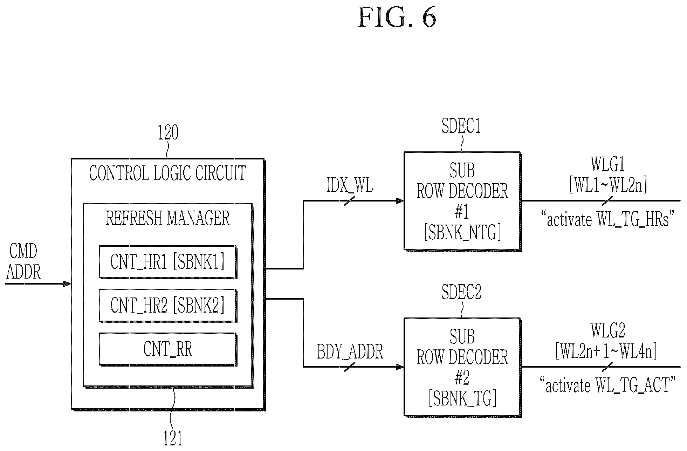

The control logic circuit 120 may include a refresh manager 121. The refresh manager 121 may manage the refresh operations performed on the memory device 100. For example, the refresh manager 121 may manage the details of how the refresh operations are performed on the memory device 100. For example, the refresh manager 121 may determine a refresh order for the plurality of memory cells included in the memory bank 140. The operation method of the refresh manager 121 is described in more detail below with reference to FIG. 6.

In an embodiment, the control logic circuit 120 may perform a regular refresh operation for the memory bank 140 based on a regular refresh command REF_REG provided from the host device 10. For example, the control logic circuit 120 may perform the regular refresh operations for each of the first sub-bank SBNK1 and the second sub-bank SBNK2, based on the regular refresh command REF_REG.

In an embodiment, the control logic circuit 120 may access one of the first sub-bank SBNK1 and the second sub-bank SBNK2 and perform a hidden refresh operation on the remaining one based on a hidden refresh command HR provided from the host device 10. For example, the control logic circuit 120 may access the first sub-bank SBNK1 based on the hidden refresh command HR for the first sub-bank SBNK1 (e.g., the hidden refresh command HR corresponding to an address ADDR for first sub-bank SBNK1) and perform the hidden refresh operation for the second sub-bank SBNK2. Conversely, the control logic circuit 120 may access the second sub-bank SBNK2 based on the hidden refresh command HR for the second sub-bank SBNK2 (e.g., the hidden refresh command HR corresponding to an address ADDR for the second sub-bank SBNK2) and perform the hidden refresh operation for the first sub-bank SBNK1. The regular refresh operation may be referred to as a first refresh operation and the hidden refresh operation may be referred to as a second refresh operation.

In an embodiment, the number of the memory cells refreshed when the hidden refresh operation is performed may be less than the number of the memory cells refreshed when the regular refresh operation is performed.

The host device 10 may include a command issuance circuit 11, a first debit counter 12, a second debit counter 13, a timer circuit 14, and a refresh scheduling circuit 15. However, the disclosure is not limited thereto, and as such, according to another embodiment, the host device may include one or more components, or omit one or more components.

The command issuance circuit 11 may issue various types of the command CMD to control the memory device 100. For example, the command issuance circuit 11 may issue various types of the command CMD to the memory device 100. The various types of the command CMD may include, but is not limited to, an activation command, a precharge command, a read command, a write command, the regular refresh command REF_REG, the hidden refresh command HR, etc.

The command issuance circuit 11 may issue a regular refresh command REF_REG at every regular refresh period. The regular refresh period may also be referred to as a regular refresh time point. For example, the regular refresh command may refer to a periodic refresh command. The memory device 100 may refresh some memory cells based on the regular refresh command REF_REG. In this way, the host device 10 may maintain the integrity of the data stored in memory device 100 by repeatedly issuing the regular refresh commands REF_REG.

However, the command issuance circuit 11 may not issue the regular refresh command REF_REG in a specific regular refresh period, under the control of the refresh scheduling circuit 15. That is, at the specific regular refresh period, the command issuance circuit 11 may skip issuing the regular refresh command REF_REG based on the control of the refresh scheduling circuit 15. In this case, the host device 10 may issue another command instead of issuing the regular refresh command REF_REG, which may improve the operation efficiency of the memory system MS. In an example case in which the memory device 100 does not perform the regular refresh operations, the host device 10 may be able to perform input/output operations to the memory device 100. The manner in which the command issuance circuit 11 skip issuing the regular refresh command REF_REG based on the control of the refresh scheduling circuit 15 is described in detail below.

The first debit counter 12 may manage a first debit count DCNT1. The first debit count DCNT1 may indicate the level of which how much the refresh operation for the first sub-bank SBNK1 is needed.

The first debit counter 12 may decrease the first debit count DCNT1 whenever the command issuance circuit 11 issues the command indicating the refresh operation for the first sub-bank SBNK1. For example, the first debit counter 12 may decrease the first debit count DCNT1 in an example case in which the command issuance circuit 11 issues the regular refresh command REF_REG, or the hidden refresh command HR for the second sub-bank SBNK2.

The first debit counter 12 may increase the first debit count DCNT1 at every regular refresh period.

The second debit counter 13 may manage a second debit count DCNT2. The second debit count DCNT2 may indicate the level of which how much the refresh operation for the second sub-bank SBNK2 is needed.

The second debit counter 13 may decrease the second debit count DCNT2 whenever the command issuance circuit 11 issues the command indicating the refresh operation for the second sub-bank SBNK2. For example, the second debit counter 13 may decrease the second debit count DCNT2 in an example case in which the command issuance circuit 11 issues the regular refresh command REF_REG or the hidden refresh command HR for the first sub-bank SBNK1.

The second debit counter 13 may increase the second debit count DCNT2 at every regular refresh period.

The timer circuit 14 may detect the regular refresh period. For example, the timer circuit 14 may generate 'a regular refresh period notification' whenever the regular refresh period elapses. The timer circuit 14 may provide 'the regular refresh period notification' to other components in the host device 10. That is, each component of the host device 10 may identify the regular refresh period based on the timer circuit 14.

The refresh scheduling circuit 15 may control the operation of the command issuance circuit 11 based on the first debit count DCNT1 and the second debit count DCNT2. For example, the refresh scheduling circuit 15 may determine whether the command issuance circuit 11 skips issuing the regular refresh command REF_REG in the regular refresh period based on the first debit count DCNT1 and the second debit count DCNT2. For example, the refresh scheduling circuit 15 may determine the need for the refresh for the first sub-bank SBNK1 and the second sub-bank SBNK2 based on the first debit count DCNT1 and the second debit count DCNT2. In an example case in which there is no need to refresh the first sub-bank SBNK1 and the second sub-bank SBNK2 (e.g., no need to refresh all sub-banks included in memory bank 140), the refresh scheduling circuit 15 may control the command issuance circuit 11 to skip issuing the regular refresh command REF_REG. For example, if the first debit count DCNT1 and the second debit count DCNT2 have sufficiently low values, the refresh scheduling circuit 15 may control the command issuance circuit 11 to skip issuing the regular refresh command REF_REG.

That is, according to the embodiment of the disclosure, in an example case in which the command issuance circuit 11 issues the sufficient number of the hidden refresh command HR for each of the first sub-bank SBNK1 and the second sub-bank SBNK2, the refresh scheduling circuit 15 may control the command issuance circuit 11 to skip issuing the regular refresh command REF_REG. In this case, while the integrity of the data stored in the memory device 100 is guaranteed, the time allowed for memory device 100 to perform the regular refresh operations may be reduced. Accordingly, the time for the host device 10 to access the memory bank 140 may be extended, so the operation efficiency of the memory system MS may be improved.

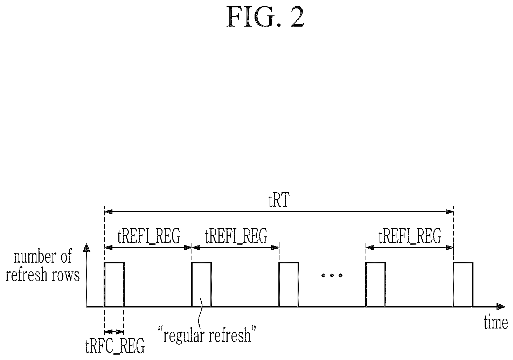

FIG. 2 is a drawing showing a regular refresh operation of a memory system of FIG. 1. A horizontal axis of FIG. 2 represents time, and a vertical axis may represent the number of memory cell rows refreshed by the memory device 100 per unit time.

Referring to FIG. 1 and FIG. 2, the memory device 100 may perform the regular refresh operation during a regular refresh consumption time tRFC_REG based on the regular refresh command REF_REG. For example, the memory device 100 may refresh some of the plurality of memory cells included in the memory bank 140 based on the regular refresh command REF_REG. Therefore, to refresh all the memory cells included in the memory bank 140, the memory device 100 may have to perform the regular refresh operation numerous times.

The length of time for which the integrity of the data stored in a memory cell is guaranteed without the refresh operation may be referred to as a retention time tRT. To ensure the integrity of the data stored in all memory cells of the memory bank 140, each memory cell must be refreshed at least once within the retention time tRT.

In an embodiment, whenever performing the regular refresh operation within one retention time tRT, the memory device 100 may refresh different combinations of the memory cell rows. For example, the host device 10 may issue a first regular refresh command and a second regular refresh command within one retention time tRT. In this case, the memory device 100 may refresh a first plurality of memory cell rows based on the first regular refresh command, and may refresh a second plurality of memory cell rows that are different from the first plurality of memory cell rows based on the second regular refresh command.

To ensure the integrity of the data stored in all memory cells of the memory bank 140, the host device 10 may issue a predetermined number of the regular refresh commands REF_REG during the retention time tRT. For example, the host device 10 may issue the regular refresh command REF_REG 8192 times during the retention time tRT. However, the scope of the disclosure is not limited to the number of the regular refresh commands REF_REG issued by the host device 10 during the retention time tRT.

The host device 10 may issue the regular refresh command REF_REG every regular refresh period, to issue a predetermined number(e.g., a number needed for guaranteeing integrity) of the regular refresh commands REF_REG during the retention time tRT. That is, the host device 10 may issue the regular refresh command REF_REG whenever a time corresponding to a regular refresh interval tREFI_REG has elapsed. For example, the timer circuit 14 may generate 'the regular refresh period notification' whenever the regular refresh interval tREFI_REG elapses. The command issuance circuit 11 may issue the regular refresh command REF_REG whenever 'the regular refresh period notification' is received.

In an embodiment, a product of a number of the regular refresh commands REF_REG issued by the host device 10 during the retention time tRT and a regular refresh interval tREFI_REG may correspond to the retention time tRT. However, the scope of the disclosure is not limited thereto.

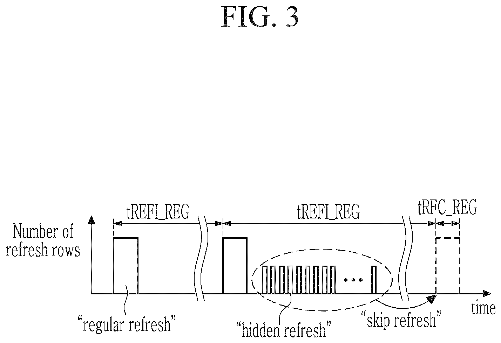

FIG. 3 is a drawing showing a hidden refresh operation of a memory system of FIG. 1. A horizontal axis of FIG. 3 may represent a time, and a vertical axis may represent the number of the memory cell rows refreshed by the memory device of 100 per unit time.

Referring to FIG. 1 to FIG. 3, the host device 10 may issue a plurality of hidden refresh commands HR within a single regular refresh interval tREFI_REG. The memory device 100 may perform the hidden refresh operation based on the plurality of hidden refresh commands HR, respectively. For example, the memory device 100 may perform the hidden refresh operation for the second sub-bank SBNK2 based on the hidden refresh command HR for the first sub-bank SBNK1, and may perform the hidden refresh operation for the first sub-bank SBNK1 based on the hidden refresh command HR for the second sub-bank SBNK2.

In an embodiment, whenever performing the hidden refresh operation within one regular refresh interval tREFI_REG, the memory device 100 may refresh different combinations of the memory cell rows. For example, the host device 10 may issue a first hidden refresh command and a second hidden refresh command within one regular refresh interval tREFI_REG. In this case, the memory device 100 may refresh a first group of memory cell rows based on the first hidden refresh command, and refresh a second group of memory cell rows that do not overlap with the first group based on the second hidden refresh command.

A number of the memory cell rows refreshed when the memory device 100 performs one hidden refresh operation may be less than a number of the memory cell rows refreshed when the memory device 100 performs one regular refresh operation. Therefore, the memory device 100 may refresh the memory cell rows corresponding to one regular refresh operation by performing the hidden refresh operations a plurality of times.

In an embodiment, the memory device 100 may perform the hidden refresh operation to pre-refresh the memory cell rows to be refreshed during the next regular refresh operation. In this way, the memory device 100 may replace the regular refresh operation with the plurality of hidden refresh operations.

In an example case in which the hidden refresh operation for the first sub-bank SBNK1 and the hidden refresh operation for the second sub-bank SBNK2 are sufficiently performed within one regular refresh interval tREFI_REG, the host device 10 may skip issuing the regular refresh command REF_REG for the next regular refresh period. That is, in an example case in which both the hidden refresh command HR for the first sub-bank SBNK1 and the hidden refresh command HR for the second sub-bank SBNK2 are issued by the sufficient number of times within one regular refresh interval tREFI_REG, the host device 10 may not issue the regular refresh command REF_REG in the next regular refresh period.

For example, the first debit counter 12 may decrease the first debit count DCNT1 whenever the hidden refresh command HR for the second sub-bank SBNK2 is issued, and the second debit counter 13 may decrease the second debit count DCNT2 whenever the hidden refresh command HR for the first sub-bank SBNK1 is issued. The refresh scheduling circuit 15 may control whether to issue the regular refresh command REF_REG of the command issuance circuit 11 in the next regular refresh period based on the first debit count DCNT1 and the second debit count DCNT2. In an example case in which both the first debit count DCNT1 and the second debit count DCNT2 are sufficiently small, the refresh scheduling circuit 15 may control the command issuance circuit 11 to skip issuing the regular refresh command REF_REG in the next regular refresh period. For example, based on both the first debit count DCNT1 and the second debit count DCNT2 being below a reference value, the refresh scheduling circuit 15 may control the command issuance circuit 11 to skip issuing the regular refresh command REF_REG in the next regular refresh period.

Meanwhile, the hidden refresh command HR may represent the hidden refresh operation together with any type of the operation of memory device 100. For example, the host device 10 may issue the hidden refresh command HR to instruct the memory device 100 to perform the hidden refresh operation, and simultaneously to instruct the memory device 100 to perform various types of operations, such as activation, read, write, precharge, etc. For brief description, in the following, it is assumed that the hidden refresh command HR indicates the activation operation and the hidden refresh operation. However, the scope of the disclosure is not limited thereto. For example, the hidden refresh command HR may also indicate various types of operations, such as read operation, write operation, precharge operation, etc., along with the hidden refresh operation.

The memory device 100 may perform not only the hidden refresh operation, but also any type of the operation of the memory device 100 based on the hidden refresh command HR. For example, the memory device 100, based on the hidden refresh command HR, may control (e.g., activate) the first sub-bank SBNK1 and simultaneously perform the hidden refresh operation for the second sub-bank SBNK2, or control (e.g., activate) the second sub-bank SBNK2 and simultaneously perform the hidden refresh operation for the first sub-bank SBNK1. That is, while the memory device 100 controls the specific sub-bank SBNK, the hidden refresh operations for other sub-bank SBNK may be performed in the background. For example, while the memory device 100 controls the specific sub-bank SBNK, the hidden refresh operations for other sub-bank SBNK may be performed simultaneously in the background. Accordingly, even in an example case in which the hidden refresh operation is performed, there may be no restrictions on the input/output operations of the memory device 100. As a result, according to the embodiment of the disclosure, since the regular refresh operation may be replaced with the hidden refresh operation, the host device 10 may access the memory device 100 even during the regular refresh consumption time tRFC_REG. In this case, the time allowed for the host device 10 to access the memory device 100 may be extended, so the operation efficiency and operation performance of the memory system MS may be improved.

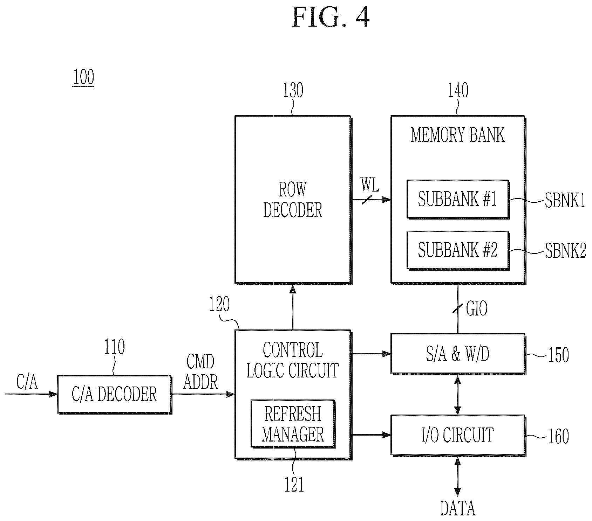

FIG. 4 is a block diagram showing a memory device of FIG. 1 in more detail. Referring to FIG. 1 to FIG. 4, a memory device 100 may include a command/address (C/A) decoder 110, a control logic circuit 120, a row decoder 130, a memory bank 140, a sense amplifier (S/A) & write driver (W/D) 150, and an input/output (I/O) circuit 160.

The command/address decoder 110 may receive command/address signals C/A provided from the host device 10. The command/address decoder 110 may decode the command/address signals C/A into a command CMD and an address ADDR. For example, the command/address decoder 110 may receive the command CMD and the address ADDR from the host device 10 in the format of the command/address signals C/A.

The control logic circuit 120 may receive the command CMD and the address ADDR. The control logic circuit 120 may control overall operations of the memory device 100 based on the command CMD and the address ADDR. For example, the control logic circuit 120 may control the operations of a row decoder 130, a sense amplifier & write driver 150, and an input/output circuit 160 based on the command CMD and the address ADDR.

The row decoder 130 may be connected to the memory bank 140 with a plurality of word lines WL. The row decoder 130 may control the plurality of word lines WL based on the control of the control logic circuit 120. For example, the row decoder 130 may activate some of the plurality of word lines WL based on the control from the control logic circuit 120.

The memory bank 140 may be connected to the row decoder 130 with the plurality of word lines WL, and connected to the sense amplifier & write driver 150 with a plurality of global input/output lines GIO.

The memory bank 140 may include a plurality of sub-banks SBNK. For example, the memory bank 140 may include a first sub-bank SBNK1 and a second sub-bank SBNK2. Each of the first sub-bank SBNK1 and the second sub-bank SBNK2 may be connected to a group of word lines WL different each other. The first sub-bank SBNK1 and the second sub-bank SBNK2 may be connected to the plurality of global input/output lines GIO.

In an embodiment, the number of the word lines WL connected to the first sub-bank SBNK1 and the number of the word lines WL connected to the second sub-bank SBNK2 may be equal to each other. However, the scope of the disclosure is not limited thereto.

Each of the first sub-bank SBNK1 and the second sub-bank SBNK2 may include a plurality of memory cells arranged in a matrix format. In an embodiment, each of the plurality of memory cells included in the first sub-bank SBNK1 and the second sub-bank SBNK2 may be a dynamic random access memory (DRAM) cell, but the scope of the disclosure is not limited thereto.

The sense amplifier & write driver 150 may be connected to the memory bank 140 with the plurality of global input/output lines GIO. The sense amplifier & write driver 150 may receive the data from the memory bank 140 through the plurality of global input/output lines GIO or store the data DATA in the memory bank 140 through the plurality of global input/output lines GIO based on the control of the control logic circuit 120.

The input/output circuit 160 may communicate with the host device 10. For example, the input/output circuit 160 may provide the data DATA received from the host device 10 to the sense amplifier & write driver 150, or may transmit the data DATA provided from the sense amplifier & write driver 150 to the host device 10.

The control logic circuit 120 may include a refresh manager 121. The refresh manager 121 may generate a list of the word lines WL to be activated based on a regular refresh command REF_REG and/or a hidden refresh command HR. The refresh manager 121 may provide the row decoder 130 with the list of word lines WL to be activated. In this case, the row decoder 130 may activate some of the plurality of word lines WL based on the received list.

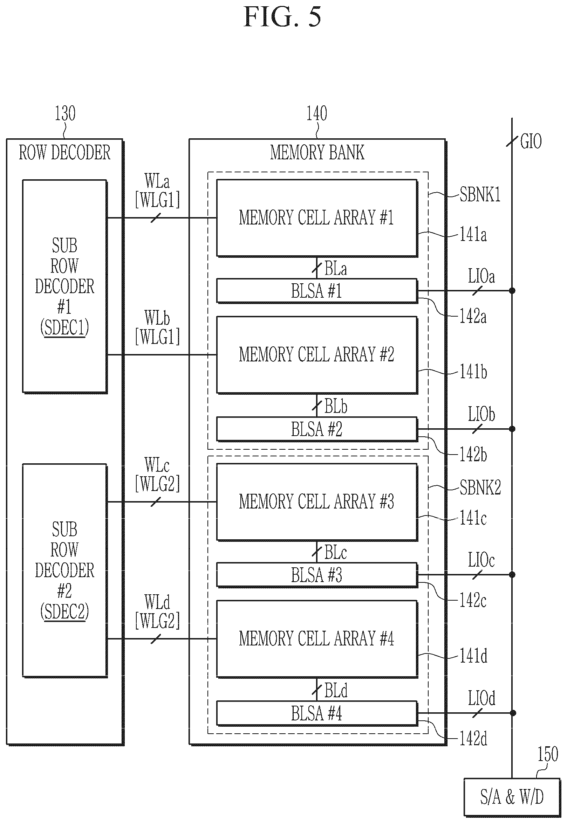

FIG. 5 is a drawing showing some of the components of FIG. 4 in more detail. Referring to FIG. 1 to FIG. 5, the row decoder 130 may include a first sub-row decoder SDEC1 and a second sub-row decoder SDEC2.

The first sub-row decoder SDEC1 may be connected to the first sub-bank SBNK1 through a first word line group WLG1. The second sub-row decoder SDEC2 may be connected to the second sub-bank SBNK2 through a second word line group WLG2. Each of the first word line group WLG1 and the second word line group WLG2 may include a plurality of word lines WL. The word lines WL included in the first word line group WLG1 may be different from the word lines WL included in the second word line group WLG2.

Each of the first sub-bank SBNK1 and the second sub-bank SBNK2 may include a plurality of memory cell arrays 141 and a plurality of bit line sense amplifiers 142. For a more concise explanation, in the following, it is assumed that the first sub-bank SBNK1 and the second sub-bank SBNK2 each include two pairs of memory cell array 141 and bit line sense amplifier 142. For example, the first sub-bank SBNK1 may include a first memory cell array 141a, a second memory cell array 141b, a first bit line sense amplifier 142a, and a second bit line sense amplifier 142b. The second sub-bank SBNK2 may include a third memory cell array 141c, a fourth memory cell array 141d, a third bit line sense amplifier 142c, and a fourth bit line sense amplifier 142d. However, the scope of the disclosure is not limited to the number of the pairs of the memory cell array 141 and the bit line sense amplifier 142 included in each of the first sub-bank SBNK1 and the second sub-bank SBNK2.

Each of the memory cell arrays 141 included in the first sub-bank SBNK1 may be connected to the first sub-row decoder SDEC1. For example, the first memory cell array 141a may be connected to the first sub-row decoder SDEC1 through the first plurality of word lines WLa. The second memory cell array 141b may be connected to the first sub-row decoder SDEC1 through the second plurality of word lines WLb. In this case, the first word line group WLG1 may include the first plurality of word lines WLa and the second plurality of word lines WLb.

Each of the memory cell arrays 141 included in the second sub-bank SBNK2 may be connected to the second sub-row decoder SDEC2. For example, the third memory cell array 141c may be connected to the second sub-row decoder SDEC2 through the third plurality of word lines WLc. The fourth memory cell array 141d may be connected to the second sub-row decoder SDEC2 through the fourth plurality of word lines WLd. In this case, the second word line group WLG2 may include the third plurality of word lines WLc and the fourth plurality of word lines WLd.

The first memory cell array 141a may be connected to the first bit line sense amplifier (BLSA) 142a through the first plurality of bit lines BLa. The first bit line sense amplifier 142a may be connected to the plurality of global input/output lines GIO through the first plurality of local input/output lines LIOa.

The second memory cell array 141b may be connected to the second bit line sense amplifier (BLSA) 142b through the second plurality of bit lines BLb. The second bit line sense amplifier 142b may be connected to the plurality of global input/output lines GIO through the second plurality of local input/output lines LIOb.

The third memory cell array 141c may be connected to a third bit line sense amplifier (BLSA) 142c through a third plurality of bit lines BLc. The third bit line sense amplifier 142c may be connected to the plurality of global input/output lines GIO through the third plurality of local input/output lines LIOc.

The fourth memory cell array 141d may be connected to a fourth bit line sense amplifier (BLSA) 142d through a fourth plurality of bit lines BLd. The fourth bit line sense amplifier 142d may be connected to the plurality of global input/output lines GIO through the fourth plurality of local input/output lines LIOd.

The sense amplifier & write driver 150 may be connected to the plurality of global input/output lines GIO. The sense amplifier & write driver 150 may provide data represented by the voltage levels of the plurality of global input/output lines GIO to the input/output circuit 160, or control the voltage levels of the plurality of global input/output lines GIO based on the data provided from the input/output circuit 160.

For brief description, FIG. 5 shows the plurality of local input/output lines LIO and the plurality of global input/output lines GIO as being directly connected, but the scope of the disclosure is not limited thereto. For example, various types of components, such as a local sense amplifier, may be further connected between the plurality of local input/output lines LIO and the plurality of global input/output lines GIO.

The first sub-row decoder SDEC1 may activate one or more of the word lines included in the first word line group WLG1 based on the control of the control logic circuit 120, and the second sub-row decoder SDEC2 may activate one or more of the word lines included in the second word line group WLG2 based on the control of the control logic circuit 120. Below, for a more concise explanation, the operation of the first memory cell array 141a and the first bit line sense amplifier 142a in an example case in which the first sub-row decoder SDEC1 activates one of the first plurality of word lines WLa is representatively described. However, the scope of the disclosure is not limited thereto.

The first sub-row decoder SDEC1 may activate one of the first plurality of word lines WLa. In this case, the voltage level of the first plurality of bit lines BLa may be changed based on the data stored in the memory cells connected to an activated word line WL. The first bit line sense amplifier 142a may detect and amplify voltage level changes of the first plurality of bit lines BLa, and temporarily store the data stored in the memory cells connected to the activated word line WL.

The first bit line sense amplifier 142a may restore the temporarily stored data to the memory cells connected to the activated word line WL. In this way, in an example case in which the specific word line WL is activated, the memory cell row connected to the activated word line WL may be refreshed.

In an embodiment, the first bit line sense amplifier 142a may transmit the temporarily stored data to the plurality of global input/output lines GIO through the first plurality of local input/output lines LIOa.

In an embodiment, the first bit line sense amplifier 142a may control the voltage level of the first plurality of bit lines BLa based on the voltage level of the first plurality of local input/output lines LIOa.

Referring to FIG. 4, the control logic circuit 120 may perform the regular refresh operation for each of the plurality of sub-banks SBNK based on the regular refresh command REF_REG. For example, the control logic circuit 120 may refresh one or more memory cell rows for each of the plurality of memory cell arrays 141. For example, the control logic circuit 120 may control the row decoder 130 to sequentially activate one or more of the first plurality of word lines WLa, one or more of the second plurality of word lines WLb, one or more of the third plurality of word lines WLc, and one or more of the fourth plurality of word lines WLd. However, the scope of the disclosure is not limited thereto, and the control logic circuit 120 may not activate the word lines connected to some memory cell arrays 141 based on the regular refresh command REF_REG.

That is, in an example case in which the control logic circuit 120 performs the regular refresh operation, the refresh operation may be performed for both the first sub-bank SBNK1 and the second sub-bank SBNK2. In this case, the host device 10 may not be allowed to issue any other command CMD (e.g., an activation command) for the memory bank 140 until the regular refresh operation is completed.

Referring to FIGS. 4 and 5, the control logic circuit 120 may control one sub-bank SBNK and simultaneously perform the hidden refresh operation for the other sub-bank SBNK, based on the hidden refresh command HR. For example, the control logic circuit 120 may activate one word line WL included in the second word line group WLG2 and one or more word lines WL included in the first word line group WLG1, based on the hidden refresh command HR for the second sub-bank SBNK2.

That is, the control logic circuit 120 may perform the hidden refresh operation just for one of the first sub-bank SBNK1 and the second sub-bank SBNK2. In this case, the host device 10 may be able to access the sub-bank SBNK where the hidden refresh operation is not performed.

FIG. 6 is a drawing for illustrating a method of controlling sub-row decoders of FIG. 5. Referring to FIG. 1 to FIG. 6, the refresh manager 121 of the control logic circuit 120 may manage a first hidden refresh count CNT_HR1, a second hidden refresh count CNT_HR2, and a regular refresh count CNT_RR.

The first hidden refresh count CNT_HR1 may represent a number of times that the hidden refresh has been performed for the first sub-bank SBNK1, the second hidden refresh count CNT_HR2 may represent a number of times that the hidden refresh has been performed for the second sub-bank SBNK2, and the regular refresh count CNT_RR may represent a number of times that the regular refresh has been performed for memory bank 140.

The first sub-row decoder SDEC1 may control the first word line group WLG1. For example, the first sub-row decoder SDEC1 may control the first to 2n-th word lines WL1 to WL2n.

In an embodiment, the number of the first plurality of word lines WLa may be equal to the number of the second plurality of word lines WLb. For example, the first plurality of word lines WLa may be a first to n-th word lines WL1 to WLn, and the second plurality of word lines WLb may be (n+1)-th to 2n-th word lines WLn+1 to WL2n.

The second sub-row decoder SDEC2 may control the second word line group WLG2. For example, the second sub-row decoder SDEC2 may control the (2n+1)-th to 4n-th word lines WL2n+1 to WL4n.

In an embodiment, the number of the third plurality of word lines WLc may be equal to the number of the fourth plurality of word lines WLd. For example, the third plurality of word lines WLc may be (2n+1)-th to 3n-th word lines WL2n+1 to WL3n, and the fourth plurality of word lines WLd may be (3n+1)-th to 4n-th word lines WL3n+1 to WL4n.

The first word line group WLG1 and the second word line group WLG2 may correspond to different row address ranges. For example, each of the first to 2n-th word lines WL1 to WL2n may correspond to the different row addresses within the first row address range, and the 2n+1 to 4n-th word lines WL2n+1 to WL4n may correspond to the different row addresses within the second row address range. In this case, an address range identifier each of the row addresses included in the first row address range may have a first value, and an address range identifier of each the row addresses included in the second row address range may have a second value.

In an embodiment, the address range identifier may refer to some bits within the row address that are used to identify the sub-row decoder SDEC corresponding to the row address. For example, the address range identifier may be a most significant bit (MSB) of the row address. In this case, the control logic circuit 120 may identify the sub-row decoder SDEC corresponding to the row address based on the MSB of the row address. However, the range of the disclosure is not limited thereto, and the address range identifier may be determined by a combination of any bits included in the row address. However, for a more concise explanation, an embodiment in which the address range identifier is the MSB of the row address will be described representatively.

In an embodiment, the address range identifier (e.g., the MSB) of each row address included in the first row address range may be '0', and the address range identifier of each row address included in the second row address range may be '1'.

In an embodiment, the control logic circuit 120 may identify a code length of an address range identifier included in the row address based on the number of the sub-bank SBNK included in the memory bank 140. In an example case in which the number of sub-bank SBNKs included in the memory bank 140 is 2, the control logic circuit 120 may identify the address range identifier included in the row address as 1-bit. In this case, the control logic circuit 120 is able to distinguish between the two (e.g., 2¹) sub-bank SBNKs based on the 1-bit address range identifier. Similarly, in an example case in which the number of the sub-bank SBNKs included in the memory bank 140 is 4, the control logic circuit 120 may identify the address range identifier included in the row address as 2-bits. In this case, the control logic circuit 120 is able to distinguish four (e.g., 2²) sub-bank SBNKs based on the 2-bit address range identifier.

The control logic circuit 120 may receive a command CMD and an address ADDR corresponding to the command CMD. The address ADDR may be provided to the memory device 100 together with the command CMD, or may be provided to the memory device 100 together with another command received prior to the command CMD. The control logic circuit 120 may control the first sub-row decoder SDEC1 and the second sub-row decoder SDEC2 based on the command CMD and the address ADDR.

In an example case in which the command CMD provided to the control logic circuit 120 is the hidden refresh command HR, the control logic circuit 120 may identify the sub-bank SBNK corresponding to the address ADDR as a target sub-bank SBNK_TG, and may identify a sub-bank other than the target sub-bank SBNK_TG as a non-target sub-bank SBNK_NTG. In an example case in which the MSB bit of the row address included in the address ADDR is '1', the control logic circuit 120 may identify the second sub-bank SBNK2 as the target sub-bank SBNK_TG and may identify the first sub-bank SBNK1 as the non-target sub-bank SBNK_NTG. In this case, the control logic circuit 120 may perform the hidden refresh operation for the non-target sub-bank SBNK_NTG while controlling the target sub-bank SBNK_TG (e.g., while activating the target sub-bank SBNK_TG).

The row address included in the address ADDR may indicate the activation target word line WL_TG_ACT. The control logic circuit 120 may identify the address range identifier and the address body BDY_ADDR of the row address included in the address ADDR. The description of how the control logic circuit 120 identifies the address range identifier is similar to that described above, and is not described in further detail. The control logic circuit 120 may identify remaining bits of the row address included in the address ADDR (e.g., bits excluding the address range identifier), as the address body BDY_ADDR.

The control logic circuit 120 may control the target sub-bank SBNK_TG based on the address body BDY_ADDR. For example, the control logic circuit 120 may provide the address body BDY_ADDR to the second sub-row decoder SDEC2. In this case, the second sub-row decoder SDEC2 may activate the activation target word line WL_TG_ACT corresponding to the address body BDY_ADDR.

The refresh manager 121 may determine one or more hidden refresh target word lines WL_TG_HR based on the regular refresh count CNT_RR and the hidden refresh count CNT_HR corresponding to the non-target sub-bank SBNK_NTG. For example, the refresh manager 121 may generate one or more word line indexes IDX_WL respectively corresponding to one or more hidden refresh target word lines WL_TG_HR, based on the first hidden refresh count CNT_HR1 and the regular refresh count CNT_RR.

The control logic circuit 120 may control the non-target sub-bank SBNK_NTG based on the one or more word line indexes IDX_WL generated by the refresh manager 121. For example, the control logic circuit 120 may provide one or more word line indexes IDX_WL to the first sub-bank SBNK1. In this case, the first sub-row decoder SDEC1 may activate one or more hidden refresh target word lines WL_TG_HR based on one or more word line indexes IDX_WL. Afterwards, refresh manager 121 may increase the first hidden refresh count CNT_HR1 by '1'. That is, the refresh manager 121 may increase the first hidden refresh count CNT_HR1 by '1' based on the hidden refresh command HR for the second sub-bank SBNK2.

In an embodiment, the code length of each word line index IDX_WL may be equal to the code length of the address body BDY_ADDR.

In an embodiment, the refresh manager 121 may determine one or more word line indexes IDX_WL differently for each combination of the first hidden refresh count CNT_HR1 and the regular refresh count CNT_RR, so as to prevent the same memory cell row from being unnecessarily refreshed repeatedly within the retention time tRT.

In an embodiment, one or more word line indexes IDX_WL generated by the refresh manager 121 based on one hidden refresh command HR may correspond to the different memory cell arrays 141. For example, one or more word line index IDX_WL may be one of the first plurality of word lines WLa and one of the second plurality of word lines WLb. In this case, since the first memory cell array 141a and the second memory cell array 141b are connected to the different bit line sense amplifiers 142, the first sub-row decoder SDEC1 may perform the hidden refresh operation for the plurality of memory cell rows by simultaneously activate the word lines WL respectively corresponding to one or more word line indexes IDX_WL.

For a more concise explanation, although an embodiment in which the control logic circuit 120 performs the hidden refresh operation for the first sub-bank SBNK1 and the activation operation for the second sub-bank SBNK2 has been representatively described with FIG 6, the scope of the disclosure is not limited thereto. For example, the control logic circuit 120 may perform the hidden refresh operation for the second sub-bank SBNK2 and the activation operation for the first sub-bank SBNK1.

In an embodiment, in an example case in which the command CMD provided to the control logic circuit 120 is an activation command, the control logic circuit 120 may activate the word line WL indicated by the address ADDR. In an example case in which the MSB of the row address included in the address ADDR is '1', the control logic circuit 120 may control the second sub-row decoder SDEC2 to activate the activation target word line WL_TG_ACT corresponding to the address ADDR.

In an embodiment, in an example case in which the command CMD provided to the control logic circuit 120 is a regular refresh command REF_REG, the control logic circuit 120 may activate the plurality of word lines WL by controlling both the first sub-row decoder SDEC1 and the second sub-row decoder SDEC2. For example, the refresh manager 121 may generate 'a regular refresh list' including one or more of the first word line groups WLG1 and one or more of the second word line groups WLG2 based on the regular refresh count CNT_RR. In this case, the first sub-row decoder SDEC1 and the second sub-row decoder SDEC2 may activate word lines indicated by 'the regular refresh list' (e.g., the refresh target word lines). Afterwards, the refresh manager 121 may increase the regular refresh count CNT_RR by '1'. That is, the refresh manager 121 may increase, based on the regular refresh command REF_REG, the regular refresh count CNT_RR by '1'.

In an embodiment, the refresh manager 121 may determine the regular refresh list differently according to the regular refresh count CNT_RR so that the same memory cell row not being refreshed within the retention time tRT. In this case, the memory cell rows from different groups may be refreshed when the plurality of regular refresh operations are performed.

In an embodiment, the refresh manager 121 may decrease the regular refresh count CNT_RR every retention time tRT. For example, the refresh manager 121 may decrease the regular refresh count CNT_RR to '0' every retention time tRT, or may decrease the regular refresh count CNT_RR by a number of the regular refresh commands REF_REG that must be received within the retention time tRT for the data integrity (e.g., 8192). However, the scope of the disclosure is not limited thereto.

In an embodiment, the refresh manager 121 may decrease the first hidden refresh count CNT_HR1 and the second hidden refresh count CNT_HR2 whenever the regular refresh operation is performed on the memory bank 140. For example, whenever the control logic circuit 120 receives the regular refresh command REF_REG, the refresh manager 121 may decrease the first hidden refresh count CNT_HR1 and the second hidden refresh count CNT_HR2 to '0'. In this way, the host device 10 may issue the plurality of hidden refresh commands HR to preemptively refresh the memory cell rows to be refreshed during the next regular refresh period.

In an embodiment, the refresh manager 121 may not initialize the first hidden refresh count CNT_HR1 and the second hidden refresh count CNT_HR2 even in an example case in which the regular refresh operation is performed. That is, the refresh manager 121 may maintain the first hidden refresh count CNT_HR1 and the second hidden refresh count CNT_HR2 even in an example case in which the regular refresh operation is performed. For example, instead of initializing the first hidden refresh count CNT_HR1 and the second hidden refresh count CNT_HR2 when the regular refresh operation is performed, the refresh manager 121 may initialize (e.g., decrease to '0') the first hidden refresh count CNT_HR1 and the second hidden refresh count CNT_HR2 every retention time tRT. In this way, the host device 10 may also perform the refresh operation for memory bank 140 by alternately issuing the hidden refresh command HR and the regular refresh command REF_REG within one retention time tRT. In this case, the refresh manager 121 may determine the regular refresh list by considering the first hidden refresh count CNT_HR1, the second hidden refresh count CNT_HR2, and the regular refresh count CNT_RR. In this case, memory cell rows which have already been refreshed through the hidden refresh operation may not be refreshed again when the regular refresh operation is performed. Accordingly, an over refresh of the memory device 100 may be prevented according to an embodiment of the disclosure, so that the operation efficiency of the memory device 100 may be improved and the power consumption of the memory device 100 may be reduced. However, the scope of the disclosure is not limited thereto.

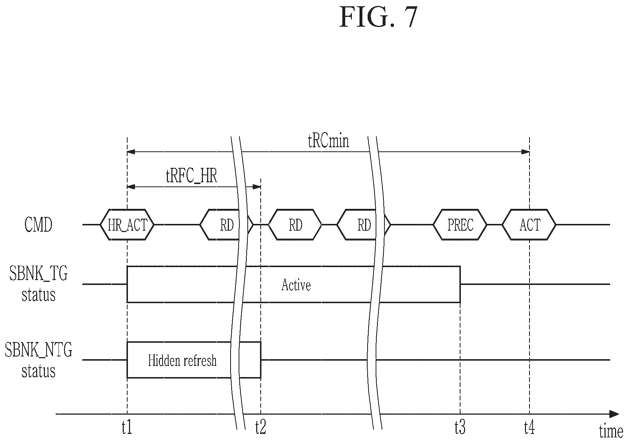

FIG. 7 is a timing diagram showing an operation of a memory device based on a hidden refresh command that instructs an activation operation and a hidden refresh operation. The horizontal axis of FIG. 7 may represent a time.

Referring to FIG. 1 to FIG. 7, the memory device 100 may receive the hidden refresh command HR at the first time point t1. For example, the memory device 100 may receive an activation-hidden refresh command HR_ACT, which indicates the activation operation and the hidden refresh operation.

In an embodiment, the host device 10 may issue the activation-hidden refresh command HR_ACT in a similar manner to the activation command ACT. For example, the host device 10 may issue the activation-hidden refresh command HR_ACT in an example case in which all timing parameters for issuing the activation command ACT are satisfied.

The memory device 100 may receive the precharge command PREC at a third time point t3.

The control logic circuit 120 may activate the target sub-bank SBNK_TG between the first time point t1 and the third time point t3 based on the activation-hidden refresh command HR_ACT. For example, the control logic circuit 120 may activate the activation target word line WL_TG_ACT during a time period between the first time point t1 and the third time point t3.

The control logic circuit 120 may perform the hidden refresh operation for the non-target sub-bank SBNK_NTG for the hidden refresh consumption time tRFC_HR based on the activation-hidden refresh command HR_ACT. For example, the control logic circuit 120 may perform the hidden refresh operation for the non-target sub-bank SBNK_NTG during a time period between the first time point t1 and the second time point t2.

The second time point t2 may be a time point earlier than the third time point t3. That is, the control logic circuit 120 may perform the hidden refresh operation for the non-target sub-bank SBNK_NTG while the target sub-bank SBNK_TG is activated. Accordingly, even in an example case in which the hidden refresh operation is performed for the non-target sub-bank SBNK_NTG, the input/output performance of the memory device 100 may not be deteriorated.

Meanwhile, until a minimum activation period time tRCmin has elapsed from the first time point t1, issuing the activation command ACT or issuing the activation-hidden refresh command HR_ACT for the memory bank 140 of the host device 10 may be prohibited. That is, the interval between issuing the activation commands ACT or issuing the activation-hidden refresh commands HR_ACT for one memory bank 140 may be equal to or greater than the minimum activation period time tRCmin. For example, the host device 10 may issue the activation command ACT for the memory bank 140 at a fourth time point t4, which the minimum activation period time tRCmin is elapsed from the first time point t1.

The hidden refresh consumption time tRFC_HR may be shorter than the minimum activation period time tRCmin. Accordingly, even in an example case in which the activation command ACT for the memory bank 140 is received at a high frequency, the phenomenon of the input/output performance for the memory bank 140 being deteriorated due to the hidden refresh operation may be prevented.

In an embodiment, the regular refresh consumption time tRFC_REG may be the time required to refresh the sufficiently large number of the memory cell rows so that the regular refresh interval tREFI_REG is not excessively short. Therefore, the larger the capacity of the memory bank 140 (e.g., the number of the word lines connected to the memory bank 140), the larger the regular refresh consumption time tRFC_REG may be.

In an embodiment, the regular refresh consumption time tRFC_REG may be longer than the minimum activation period time tRCmin. In an example case in which the capacity of memory bank 140 is greater than a specific reference value, the regular refresh consumption time tRFC_REG may be longer than the minimum activation period time tRCmin. In more detail, in an example case in which the capacity of memory bank 140 is greater than 16 MB, the regular refresh consumption time tRFC_REG may be longer than the minimum activation period time tRCmin. However, the scope of the disclosure is not limited thereto, and according to the implementation of the memory device 100, the reference value of the capacity of the memory bank 140, which makes the regular refresh consumption time tRFC_REG being longer than the minimum activation period time tRCmin, may be determined to various values, such as 1 MB, 2 MB, 4 MB, 8 MB, and 32 MB.

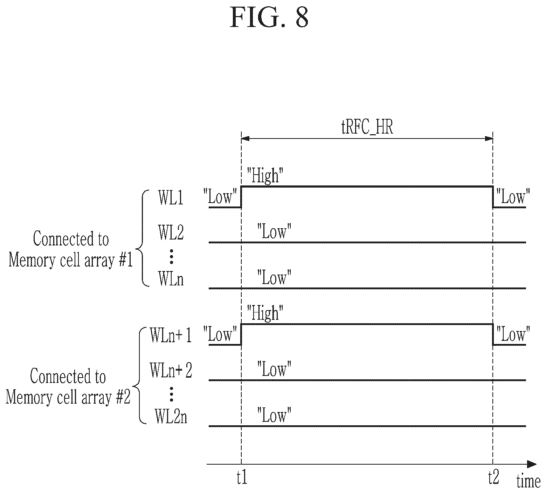

FIG. 8 is a timing diagram showing some time periods of FIG. 7 in more detail. A horizontal axis of FIG. 8 may represent a time, and a vertical axis of FIG. 8 may represent a voltage level. Referring to FIG. 1 to FIG. 8, the control logic circuit 120 may activate one or more hidden refresh target word lines WL_TG_HR connected to the non-target sub-bank SBNK_NTG between the first time point t1 and the second time point t2. For example, the control logic circuit 120 may simultaneously transition the voltage level of one of the word lines connected to the first memory cell array 141a (e.g., the first word line WL1) and one of the word lines connected to the second memory cell array 141b (e.g., the (n+1)-th word line WLn+1) to a logic high at a first time point t1. The control logic circuit 120 may set the voltage level of the remaining word lines with logic low.

In this case, each of the plurality of bit line sense amplifiers 142 included in the non-target sub-bank SBNK_NTG may refresh data stored in the memory cells connected to the word line WL in the logic high state.

For brevity, FIG. 8 illustrates an embodiment in which the control logic circuit 120 simultaneously activates the first word line WL1 and the (n+1)-th word line WLn+1 at the first time point t1, but the scope of the disclosure is not limited thereto. For example, the control logic circuit 120 may sequentially activate the first word line WL1 and the (n+1)-th word line WLn+1.

The control logic circuit 120 may maintain the voltage level of each of the plurality of word lines WL connected to the non-target sub-bank SBNK_NTG until the second time point t2. Afterwards, the control logic circuit 120 may transition the voltage level of each of one or more hidden refresh target word lines WL_TG_HR to a logic low.

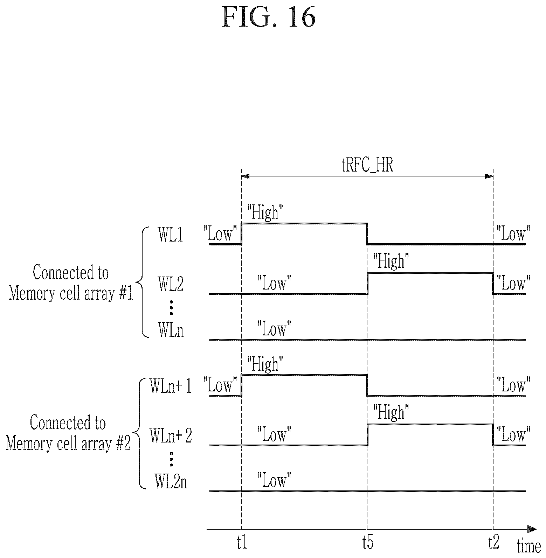

That is, the control logic circuit 120 may toggle the voltage level of one or more hidden refresh target word lines WL_TG_HR once during the hidden refresh consumption time tRFC_HR. In this case, since the memory cell rows connected to one or more hidden refresh target word lines WL_TG_HR may be refreshed simultaneously, the hidden refresh consumption time tRFC_HR may be sufficiently shorter than the minimum activation period time tRCmin. However, the scope of the disclosure is not limited thereto. An embodiment in which the control logic circuit 120 toggles the voltage level of one or more hidden refresh target word lines WL_TG_HR multiple times during the hidden refresh consumption time tRFC_HR is described in more detail below, with reference to FIG. 16.

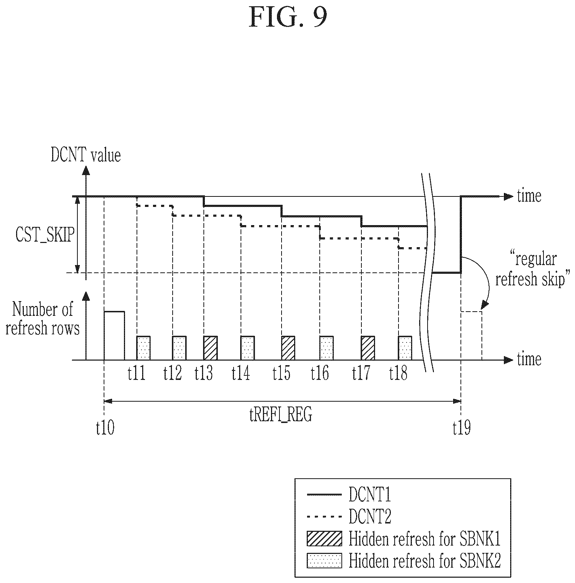

FIG. 9 is a timing diagram showing how a debit count of FIG. 1 changes based on regular refresh commands and hidden refresh commands according to an embodiment. In FIG. 9, a horizontal axis may represent a time, and a vertical axis may represent a value of a debit count DCNT or the number of the memory cell rows refreshed per unit time.

Referring to FIG. 1 to FIG. 9, at a tenth time point t10, the host device 10 may issue a regular refresh command REF_REG. In this case, the memory device 100 may perform the regular refresh operations for the first sub-bank SBNK1 and the second sub-bank SBNK2. For a more concise explanation, in the following, it is assumed that the first debit count DCNT1 and the second debit count DCNT2 are '0' at the tenth time point t10. However, the scope of the disclosure is not limited thereto.

From the tenth time point t10 until the regular refresh interval tREFI_REG has elapsed, the host device 10 may issue the plurality of hidden refresh commands HR. For example, the host device 10 may issue the hidden refresh command HR for the first sub-bank SBNK1 at eleventh time point t11, twelfth time point2 t12, fourteenth time point t14, sixteenth time point t16, and eighteenth time point t18. In this case, the memory device 100 may perform the hidden refresh operation for the second sub-bank SBNK2 at the eleventh, twelfth, fourteenth, sixteenth, and eighteenth time points t11, t12, t14, t16, and t18. The host device 10 may issue the hidden refresh command HR for the second sub-bank SBNK2 at thirteenth time point t13, fifteenth time point t15, and seventeenth time point t17. In this case, the memory device 100 may perform the hidden refresh operation for the first sub-bank SBNK1 at the thirteenth, fifteenth, and seventeenth time points t13, t15, and t17.

In an example case in which the hidden refresh is performed for the first sub-bank SBNK1 (e.g., whenever the host device 10 issues the hidden refresh command HR for the second sub-bank SBNK2), the host device 10 may decrease the first debit count DCNT1 by 'a unit redemption cost (e.g., 1)'.

In an example case in which the hidden refresh is performed for the second sub-bank SBNK2 (e.g., whenever the host device 10 issues the hidden refresh command HR for the first sub-bank SBNK1), the host device 10 may decrease the second debit count DCNT2 by 'the unit redemption cost'.

At the nineteenth time point t19 (e.g., the next regular refresh period) that the regular refresh interval tREFI_REG has elapsed from the tenth time point t10, the host device 10 may determine whether to skip issuing the regular refresh command REF_REG by determining whether the values of the first debit count DCNT1 and the second debit count DCNT2 are sufficiently low. For example, the host device 10 may determine whether to skip issuing the regular refresh command REF_REG based on whether sum of the first debit count DCNT1 and a skip cost CST_SKIP, and sum of the second debit count DCNT2 a skip cost CST_SKIP are less than or equal to '0'.

In an embodiment, in an example case in which the host device 10 skips issuing the regular refresh command REF_REG at the nineteenth time point t19, the host device 10 may increment each of the first debit count DCNT1 and the second debit count DCNT2 by the skip cost CST_SKIP.

In an embodiment, in an example case in which the host device 10 issues the regular refresh command REF_REG at the nineteenth time point t19 (e.g., does not skip issuing the regular refresh command), the host device 10 may maintain the first debit count DCNT1 and the second debit count DCNT2 respectively.

In an embodiment, the ratio of the unit redemption cost and the skip cost CST_SKIP may correspond to the ratio of the number of the memory cell rows refreshed based on the hidden refresh command HR and the number of the memory cell rows refreshed based on the regular refresh command REF_REG.

In an embodiment, the skip cost CST_SKIP may be greater than the unit redemption cost. However, the range of the disclosure is not limited thereto, and the skip cost CST_SKIP may be less than or equal to the unit redemption cost.

That is, according to the embodiment of the disclosure, in an example case in which the sufficient number of the hidden refreshes are performed for both of the first sub-bank SBNK1 and the second sub-bank SBNK2 during the regular refresh interval tREFI_REG, the host device 10 may skip issuing the regular refresh command REF_REG in the next regular refresh period. In other words, the host device 10 may replace issuing the regular refresh command REF_REG with issuing the plurality of hidden refresh commands HR to.

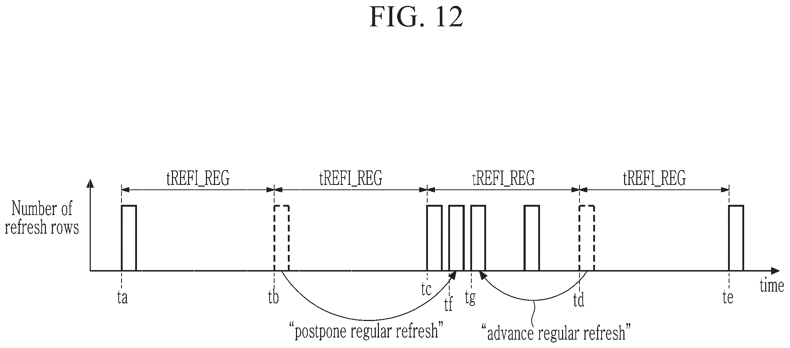

In an embodiment, the host device 10 may advance (e.g., pull-in) or postpone issuing the regular refresh command REF_REG by a reference number. The reference number may be a predetermined number. In this case, the host device 10 may skip issuing the regular refresh command REF_REG as long as the values of the first debit count DCNT1 and the second debit count DCNT2 do not fall outside a predetermined debit count range. An embodiment where the host device 10 advances or postpones issuing the regular refresh command REF_REG is described in more detail with reference to FIG. 12 to FIG. 14.

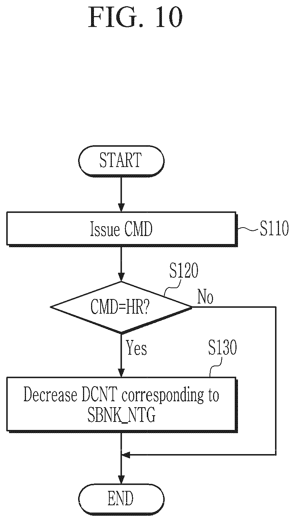

FIG. 10 is a flowchart showing an operation method of a host device managing a debit count according to the embodiment of FIG. 9.

Referring to FIG. 1 to FIG. 10, in an operation S110, the host device 10 may issue the command CMD. For example, the command issuance circuit 11 may issue the command CMD of any type.

In an operation S120, the host device 10 may determine whether the issued command CMD is a hidden refresh command HR. In an example case in which the issued command CMD is a hidden refresh command HR, a following operation S130 may be performed, and in an example case in which a issued command CMD is not the hidden refresh command HR, the operation of the host device 10 may be terminated.

In an operation S130, the host device 10 may decrease the debit count DCNT corresponding to the non-target sub-bank SBNK_NTG. In an example case in which the command CMD issued in the operation S110 is the hidden refresh command HR for the second sub-bank SBNK2, the first debit counter 12 may decrease the first debit count DCNT1 by the unit redemption cost. In an example case in which the command CMD issued in the operation S110 is the hidden refresh command HR for the first sub-bank SBNK1, the second debit counter 13 may decrease the second debit count DCNT2 by the unit redemption cost.

That is, the host device 10 may decrease the debit count DCNT corresponding to the non-target sub-bank SBNK_NTG every time it issues the hidden refresh command HR.

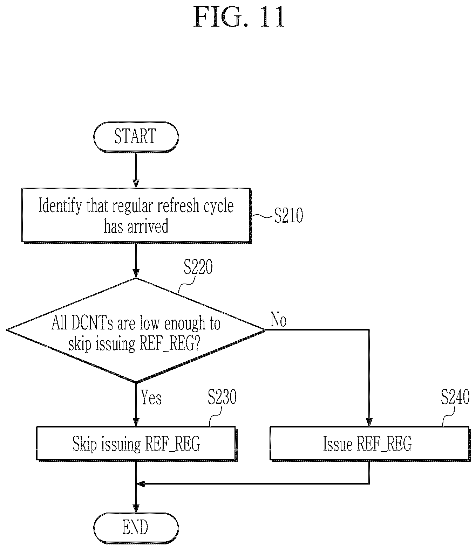

FIG. 11 is a flowchart showing an operation method of a host device based on a debit count according to the embodiment of FIG. 9.

Referring to FIG. 1 to FIG. 11, in an operation S210, the host device 10 may identify that the regular refresh period has arrived. For example, the host device 10 may generate 'the regular refresh period notification' every time the regular refresh interval tREFI_REG elapses, based on the timer circuit 14 of the host device 10.

In an operation S220, the host device 10 may determine whether all debit counts DCNT are low enough to skip issuing the regular refresh command REF_REG. For example, the refresh scheduling circuit 15 may determine whether a sum of each of the debit counts DCNT and the skip copy CST_SKIP is less than or equal to a value that '0'. In an example case in which all debit counts DCNT are determined to be sufficiently low, an operation S230 below may be performed. In an example case in which it is determined that one or more debit counts DCNT is not sufficiently low, an operation S240 below may be performed.

In the operation S230, the host device 10 may skip issuing the regular refresh command REF_REG. For example, the refresh scheduling circuit 15 may control the command issuance circuit 11 to skip issuing the regular refresh command REF_REG.

In the operation S240, the host device 10 may issue the regular refresh command REF_REG. For example, the refresh scheduling circuit 15 may control the command issuance circuit 11 to issue the regular refresh command REF_REG.

In an embodiment, after the operations S230 and S240 are performed, the host device 10 may initialize each of the plurality of debit counts DCNT. For example, the host device 10 may change the first and second debit counts DCNT to '0'. However, the scope of the disclosure is not limited thereto.

FIG. 12 is a drawing showing a regular refresh operation of a memory system of FIG. 1 according to an embodiment. In FIG. 12, a horizontal axis may represent a time, and a vertical axis may represent the number of the memory cell rows that the memory device 100 refreshes per unit time.

Referring to FIG. 1 to FIG. 8, and FIG. 12, the regular refresh period may occur at the first time point ta, the second time point tb, the third time point tc, the fourth time point td, and the fifth time point te. In this case, as previously described referring to FIG. 2, in principle, the host device 10 should issue the regular refresh command REF_REG at each of the first time point ta, the second time point tb, the third time point tc, the fourth time point td, and the fifth time point te.

However, unlike previously referring to FIG. 2, the host device 10 may advance or postpone issuing the regular refresh command REF_REG. For example, the host device 10 may advance or postpone issuing the regular refresh command REF_REG by a predetermined number of times. In this case, the host device 10 may dynamically adjust the timing at which it issues the regular refresh command REF_REG, so the operation efficiency of the memory system MS may be improved.

In an embodiment, the number of times that the host device 10 may advance or postpone issuing the regular refresh command REF_REG may be referred to as 'a refresh fluctuation threshold'.

As a more detailed example, instead of issuing the regular refresh command REF_REG in the second time point tb, the host device 10 may issue the regular refresh command REF_REG in a sixth time point tf between the third time point tc and the fourth time point td. That is, the host device 10 may postpone issuing the regular refresh command REF_REG for the second time point tb to the sixth time point tf.

Conversely, instead of issuing the regular refresh command REF_REG in the fourth time point td, the host device 10 may issue the regular refresh command REF_REG in a seventh time point tg between the third time point tc and the fourth time point td. That is, the host device 10 may advance the issuance of the regular refresh command REF_REG for the fourth time point td to the seventh time point tg.

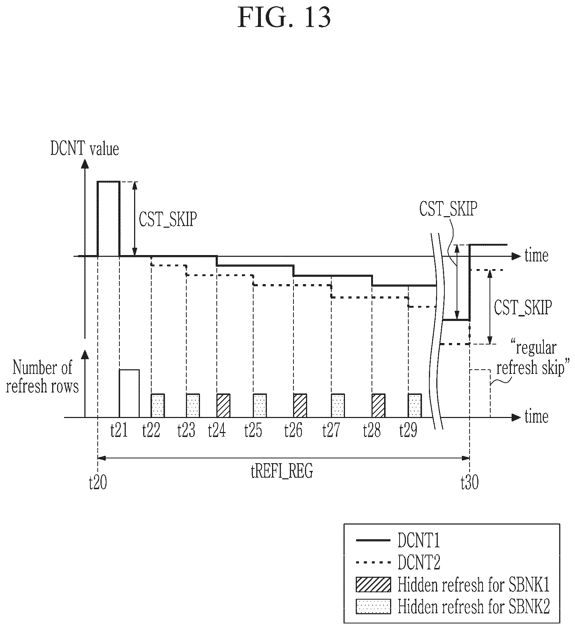

FIG. 13 is a timing diagram showing how a debit count of FIG. 1 changes based on regular refresh commands and hidden refresh commands according to an embodiment of FIG. 12. In FIG. 13, a horizontal axis may represent a time, and a vertical axis may represent a debit count value or the number of the memory cell rows refreshed per unit time.

Referring to FIG. 1 to FIG. 8, and FIG. 12 and FIG. 13, the regular refresh period may occur at the twentieth time point t20 and the thirtieth time point t30. For brief description, in the following, it is assumed that the first debit count DCNT1 and the second debit count DCNT2 are '0' before the twentieth time point t20.

The host device 10 may increase the first debit count DCNT1 and the second debit count DCNT2 by the skip cost CST_SKIP at every regular refresh period. For example, the host device 10 may increment the first debit count DCNT1 and the second debit count DCNT2 by the skip cost CST_SKIP at the twentieth time point t20 and the thirtieth time point t30, respectively.

Whenever the host device 10 issues the regular refresh command REF_REG, the host device 10 may decrease the first debit count DCNT1 and the second debit count DCNT2 by the skip cost CST_SKIP. For example, the host device 10 may issue the regular refresh command REF_REG at a twenty-first time point t21, and decrease the first debit count DCNT1 and the second debit count DCNT2 to '0'.

The host device 10 may issue the plurality of hidden refresh commands HR between the twentieth time point t20 and the thirtieth time point t30. For example, the host device 10 may issue the hidden refresh command HR for the first sub-bank SBNK1 at a twenty-second time point t22, a twenty-third time point t23, a twenty-fifth time point t25, a twenty-seventh time point t27, and a twenty-ninth time point t29. In this case, the memory device 100 may perform the hidden refresh operation for the second sub-bank SBNK2 at the twenty-second, twenty-third, twenty-fifth, twenty-seventh, and twenty-ninth time points t22, t23, t25, t27, and t29. The host device 10 may issue hidden refresh command HR for second sub-bank SBNK2 at a twenty-fourth time point t24, a twenty-sixth time point t26, and a twenty-eighth time point t28. In this case, the memory device 100 may perform the hidden refresh operation for the first sub-bank SBNK1 at a twenty-fourth, twenty-sixth, and twenty-eighth time points t24, t26, and t28.

Whenever the host device 10 issues the hidden refresh command HR for the second sub-bank SBNK2, the host device 10 may decrease the first debit count DCNT1 by ' the unit redemption cost (e.g., 1)'. Whenever the host device 10 issues the hidden refresh command HR for the first sub-bank SBNK1, the host device 10 may decrease the second debit count DCNT2 by 'the unit redemption cost'. That is, the host device 10 may manage the first debit count DCNT1 and the second debit count DCNT2 in the similar manner as described above referring to FIG. 10.

The host device 10 may determine whether to skip issuing the regular refresh command REF_REG at the thirtieth time point t30 based on each of the values of the first debit count DCNT1 and the second debit count DCNT2. In an example case in which the values of first debit count DCNT1 and second debit count DCNT2 are out of the predetermined debit count range, the refresh scheduling circuit 15 may control the command issuance circuit 11 to issue the regular refresh command REF_REG. In an example case in which the values of the first debit count DCNT1 and the second debit count DCNT2 do not over a predetermined debit count range, the refresh scheduling circuit 15 may to determine freely whether to issue (e.g., skip or postpone) the regular refresh command REF_REG, similarly described referring to FIG. 12 above.

In an example case in which the host device 10 skips or postpones issuing the regular refresh command REF_REG at thirtieth time point t30, the host device 10 may not change the first debit count DCNT1 and the second debit count DCNT2. That is, the host device 10 may maintain the first debit count DCNT1 and the second debit count DCNT2.

In an embodiment, the pre-determined debit count range may correspond to a range from: i) 'a value less than 0 by the product of the refresh fluctuation threshold and the skip cost CST_SKIP' to ii) 'a value greater than 0 by the product of the refresh fluctuation threshold and the skip cost CST_SKIP'. However, the scope of the disclosure is not limited thereto.

That is, according to the embodiment of the disclosure, the host device 10 may determine the command CMD to be issued to the memory device 100 so that both the first debit count DCNT1 and the second debit count DCNT2 do not exceed the predetermined debit count range. For example, the host device 10 may issue the regular refresh command REF_REG and the hidden refresh command HR to manage the first debit count DCNT1 and the second debit count DCNT2 so that they do not go over the predetermined debit count range.

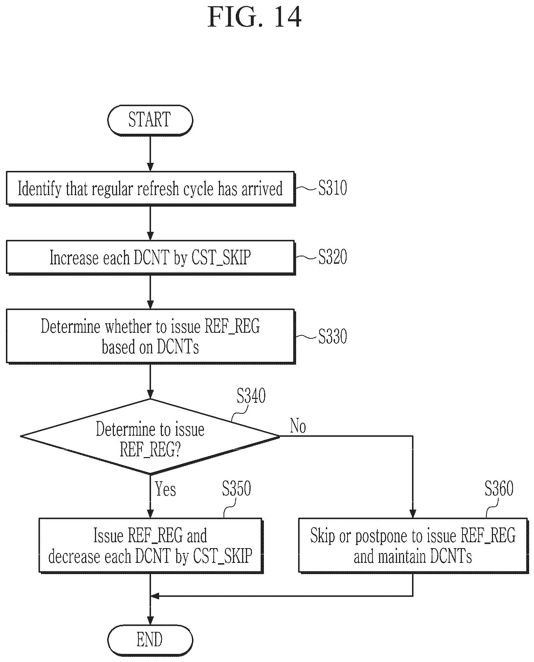

FIG. 14 is a flowchart showing an operation method of a host device based on a debit count according to the embodiment of FIG. 13.

Referring to FIG. 1 to FIG. 8, and FIG. 12 to FIG. 14, in an operation S310, the host device 10 may identify that the regular refresh period has arrived. In an operation S320, the host device 10 may increment each debit count DCNT by the skip cost CST_SKIP. For example, based on the timer circuit 14, the first debit counter 12 may increment the first debit count DCNT1 by the skip cost CST_SKIP, and the second debit counter 13 may increment the second debit count DCNT2 by the skip cost CST_SKIP.

In an operation S330, the host device 10 may determine whether to issue the regular refresh command REF_REG based on the plurality of debit counts DCNT. For example, the refresh scheduling circuit 15 may determine whether to issue the regular refresh command REF_REG, as long as each value of the first debit count DCNT1 and the second debit count DCNT2 are within the predetermined debit count range.

In an operation S340, the host device 10 may determine whether to issue the regular refresh command REF_REG. In an example case in which the host device 10 determines to issue the regular refresh command REF_REG, a following operation S350 may be performed. In an example case in which the host device 10 determines not to issue the regular refresh command REF_REG, a following operation S360 may be performed.

In the operation S350, the host device 10 may issue the regular refresh command REF_REG and decrease each debit count DCNT by the skip cost CST_SKIP. For example, the first debit counter 12 may decrease the first debit count DCNT1 by the skip cost CST_SKIP, and the second debit counter 13 may decrease the second debit count DCNT2 by the skip cost CST_SKIP.

In the operation S360, the host device 10 may skip or postpone issuing the regular refresh command REF_REG and maintain the plurality of debit counts DCNT. That is, in an example case in which the host device 10 does not issue the regular refresh command REF_REG, the host device 10 may not change the first debit count DCNT1 and the second debit count DCNT2

In an embodiment, the memory device 100 may not initialize the first hidden refresh count CNT_HR1 and the second hidden refresh count CNT_HR2 even when the regular refresh period arrives. That is, the memory device 100 may maintain the first hidden refresh count CNT_HR1 and the second hidden refresh count CNT_HR2 regardless of which operation of the operation S350 and the operation S360 is performed. However, the scope of the disclosure is not limited thereto, and the memory device 100 may also decrease the first hidden refresh count CNT_HR1 and the second hidden refresh count CNT_HR2 by a predetermined size when the regular refresh period arrives.

In an embodiment, in an example case in which the operation S350 is performed, the memory device 100 may determine the regular refresh list by considering all of the first hidden refresh count CNT_HR1, the second hidden refresh count CNT_HR2, and the regular refresh count CNT_RR. In this case, the memory cell rows that have already been refreshed through the hidden refresh operation may not be refreshed again when the regular refresh operation is performed. Accordingly, according to the embodiment of the disclosure, the over refresh of the memory device 100 may be prevented, so that the operation efficiency of the memory device 100 may be improved and the power consumption of the memory device 100 may be reduced. However, the scope of the disclosure is not limited thereto.

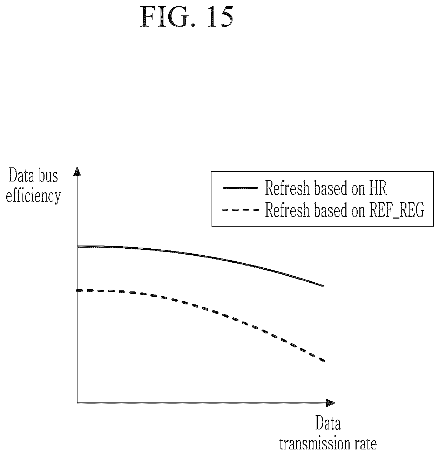

FIG. 15 is a graph showing an effect of hidden refresh according to an embodiment of the disclosure. Referring to FIG. 1 to FIG. 15, a horizontal axis of FIG. 15 may represent a data transmission rate between the memory device 100 and the host device 10. A vertical axis of FIG. 15 may represent a data bus efficiency. For example, the vertical axis of FIG. 15 may represent a ratio of a time taken to transfer data by a data bus, to an entire operation time of the memory device 100.

The data bus efficiency when the host device 10 controls the refresh operation for the memory device 100 based on the regular refresh command REF_REG is shown as a dotted line. The data bus efficiency when the host device 10 controls the refresh operations for memory device 100 based on the hidden refresh command HR is shown as a solid line.

Referring to the graph shown in the dotted line, the host device 10 may refresh the memory bank 140 by issuing the regular refresh command REF_REG every regular refresh period. In this case, the host device 10 may not be able to access the memory device 100 by the regular refresh consumption time tRFC_REG each regular refresh period.

On the other hand, referring to the graph depicted as the solid line, the host device 10 may refresh the memory bank 140 based on issuing the plurality of hidden refresh commands HR during every regular refresh period. That is, the host device 10 may replace issuing the regular refresh command REF_REG based on the plurality of hidden refresh commands HR. In this case, the regular refresh consumption time tRFC_REG may not be allocated during the operation time of the memory device 100.

Therefore, according to the embodiment of the disclosure, the phenomenon in which the communication between the host device 10 and the memory device 100 is restricted due to the regular refresh consumption time tRFC_REG may be minimized.

FIG. 16 is a timing diagram showing some sections of FIG. 7 in more detail according to an embodiment. In FIG. 16, a horizontal axis may represent a time and a vertical axis of FIG. 16 may represent a voltage level. Referring to FIG. 1 to FIG. 16, the control logic circuit 120 may sequentially activate the plurality of hidden refresh target word lines WL_TG_HR connected to the non-target sub-bank SBNK_NTG between the first time point t1 and the second time point t2. For example, the control logic circuit 120 may activate some of the plurality of hidden refresh target word lines WL_TG_HR between the first time point t1 and the fifth time point t5, and may activate some of the plurality of hidden refresh target word lines WL_TG_HR between the fifth time point t5 and the second time point t2.

For example, the control logic circuit 120 may simultaneously transition the voltage levels of the first word line WL1 and the (n+1)-th word line WLn+1 to a logic high at the first time point t1. The control logic circuit 120 may set the voltage level of the remaining word lines to a logic low. The control logic circuit 120 may maintain the voltage level of each of the plurality of word lines WL connected to the non-target sub-bank SBNK_NTG until the fifth time point t5. In this case, the memory cell rows connected to the first word line WL1 and the (n+1)-th word line WLn+1 may be refreshed.

Thereafter, the control logic circuit 120 may transition the first word line WL1 and the (n+1)-th word line WLn+1 to a logic low, and transition the second word line WL2 and the (n+2)-th word line WLn+2 to a logic high at the fifth time point t5. The control logic circuit 120 may set the voltage level of the remaining word lines to a logic low. The control logic circuit 120 may maintain the voltage level of each of the plurality of word lines WL connected to the non-target sub-bank SBNK_NTG until the second time point t2. In this case, the memory cell rows connected to the second word line WL2 and the (n+2)-th word line WLn+2 may be refreshed.

For a more concise explanation, FIG. 16 shows an embodiment in which one sub-row decoder SDEC refreshes two memory cell rows per each memory cell array 141 during the hidden refresh consumption time tRFC_HR, but the scope of the disclosure is not limited thereto. For example, one sub-row decoder SDEC may be implemented to refresh three or more memory cell rows per each memory cell array 141 during the hidden refresh consumption time tRFC_HR. For example, the memory device 100 may be implemented to refresh an any number of the memory cell rows per each memory cell array 141 in a range, such that the hidden refresh consumption time tRFC_HR being shorter than the minimum activation period time tRCmin.

That is, one sub-row decoder SDEC may refresh two or more memory cell rows for each memory cell array 141 during the hidden refresh consumption time tRFC_HR. In this case, since the number of the memory cell rows refreshed during the hidden refresh consumption time tRFC_HR may increase, the host device 10 may be needed to issue fewer hidden refresh commands HR to replace the regular refresh command REF_REG.

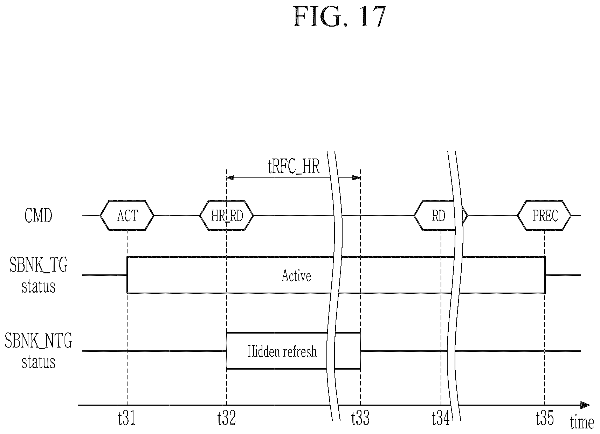

FIG. 17 is a timing diagram showing an operation of a memory device based on a hidden refresh command that instructs a read operation and a hidden refresh operation. A horizontal axis of FIG. 17 may represent a time.

Referring to FIG. 1 to FIG. 17, the host device 10 may also issue a hidden refresh command HR indicating a hidden refresh operation and a read operation. For example, the host device 10 may issue a read-hidden refresh command HR_RD at a thirty-second time point t32.

The host device 10 may issue the read-hidden refresh command (HR_RD) in a similar manner to the read command RD. That is, the host device 10 may issue the read-hidden refresh command HR_RD in an example case in which all the timing parameters for issuing the read command RD are satisfied. For example, the host device 10 may issue the activation command ACT at the thirty-first time point t31, and then issue the read-hidden refresh command HR_RD.

The control logic circuit 120 may perform the hidden refresh operation for the non-target sub-bank SBNK_NTG during the hidden refresh consumption time tRFC_HR based on the read-hidden refresh command HR_RD. For example, the control logic circuit 120 may perform the hidden refresh operation for a non-target sub-bank SBNK_NTG between the thirty-second time point t32 and the thirty-third time point t33.

The memory device 100 may receive the precharge command PREC at the thirty-fifth time point t35. The control logic circuit 120 may activate the target sub-bank SBNK_TG between the thirty-first time point t31 and the thirty-fifth time point t35 based on the activation command ACT. For example, the control logic circuit 120 may activate the activation target word line WL_TG_ACT between the thirty-first time point t31 and the thirty-fifth time point t35.

The control logic circuit 120 may access data stored in the target sub-bank SBNK_TG by issuing one or more read commands RD between the thirty-first time point t31 and the thirty-fifth time point t35 in an example case in which the target sub-bank SBNK_TG is activated. For example, the control logic circuit 120 may issue the read command RD at the thirty-fourth time point t34.

The control logic circuit 120 may perform the hidden refresh operation for the non-target sub-bank SBNK_NTG while the target sub-bank SBNK_TG is activated. Accordingly, even in an example case in which the hidden refresh operation is performed for the non-target sub-bank SBNK_NTG, the input/output performance of the memory device 100 is not deteriorated.

In an embodiment, the host device 10 may predict a time point (e.g., the thirty-fifth time point t35) when to issue the precharge command PREC for the memory bank 140, to determine whether to issue the read-hidden refresh command HR_RD. For example, the host device 10 may issue the read-hidden refresh command HR_RD only when it is predicted that the thirty-third time point t33 is earlier than the thirty-fifth time point t35.

For brief description, FIG. 17 illustrates the operation of the memory device 100 based on the hidden refresh command HR that instructs the activation operation and the read operation, but the scope of the disclosure is not limited thereto. For example, the memory device 100 may be operated in the similar manner thereto even based on the hidden refresh command HR, which instructs an activation operation and a write operation.

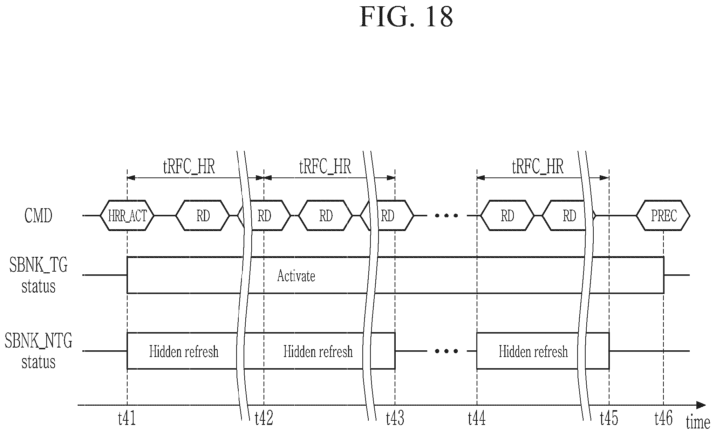

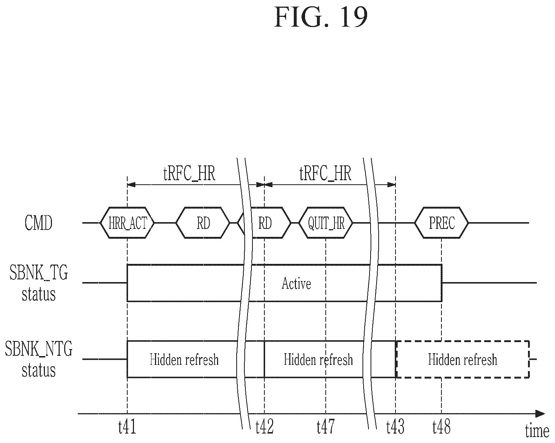

FIG. 18 and FIG. 19 are timing diagrams showing an operation of a memory system according to an embodiment. The horizontal axis of FIG. 18 and FIG. 19 may represent a time.

Referring to FIG. 1 to FIG. 16, and FIG. 18, the host device 10 may determine to sequentially access the different column addresses of one memory cell row included in the memory bank 140. For example, the host device 10 may determine to activate one memory cell row and then sequentially issue the plurality of read commands RD. In this case, host device 10 may expect that the interval between the forty-first time point t41 when the target sub-bank SBNK_TG is activated, and the forty-sixth time point t46 when the precharge command PREC is issued, is sufficiently long. Here, sufficiently long may refer to a case in which the interval between the forty-first time point t41 and the forty-sixth time point t46 is greater than a reference value. In other words, the host device 10 may predict that the access to the memory device 100 is not be restricted due to the hidden refresh operation, even in an example case in which the hidden refresh takes a long time.

The host device 10 may issue an activation-hidden refresh repetition command HRR_ACT at the forty-first time point t41. The activation-hidden refresh repetition command HRR_ACT may indicate the activation operation for one activation target word line WL and a plurality of hidden refresh operations.

In an embodiment, the host device 10 may issue the activation-hidden refresh repetition command HRR_ACT in a similar manner to the activation command ACT. For example, the host device 10 may issue the activation-hidden refresh repetition command HRR_ACT in an example case in which all timing parameters for issuing the activation command ACT are satisfied.

The memory device 100 may activate the target sub-bank SBNK_TG based on the activation-hidden refresh repetition command HRR_ACT. For example, the memory device 100 may activate the target sub-bank SBNK_TG between the forty-first time point t41 and the forty-sixth time point t46 in an example case in which the precharge command PREC is received.

The memory device 100 may perform the plurality of hidden refresh operations for the non-target sub-bank SBNK_NTG based on the activation-hidden refresh repetition command HRR_ACT. For example, the memory device 100 may perform the first hidden refresh operation for the non-target sub-bank SBNK_NTG between the forty-first time point t41 and the forty-second time point t42; and may perform the second hidden refresh operation for the non-target sub-bank SBNK_NTG between the forty-second time point t42 and the forty-third time point t43. In this way, the memory device 100 may perform a k-th (wherein, 'k' is an integer equal or greater than '1') hidden refresh operation for the non-target sub-bank SBNK_NTG between the forty-fourth time point t44 and the forty-fifth time point t45.

Each of the first to k-th hidden refresh operations may correspond to the hidden refresh operation described previously with reference to FIG. 7 and FIG. 8. For example, each of the first to k-th hidden refresh operations may be performed during the hidden refresh consumption time tRFC_HR.

In an embodiment, the number of times (e.g., 'k' times) that the memory device 100 performs the hidden refresh operation based on the activation-hidden refresh repetition command HRR_ACT may be determined in advance. However, the scope of the disclosure is not limited thereto. For example, the number of times that the memory device 100 performs the hidden refresh operation based on the activation-hidden refresh repetition command HRR_ACT may be provided from the host device 10 to the memory device 100 along with the activation-hidden refresh repetition command HRR_ACT.

In an embodiment, the refresh manager 121 may increase the hidden refresh count CNT_HR for the non-target sub-bank SBNK_NTG by '1' whenever the hidden refresh operation for the non-target sub-bank SBNK_NTG is performed.

In an embodiment, in an example case in which the activation-hidden refresh repetition command HRR_ACT is issued, the host device 10 may increase the debit count DCNT corresponding to the non-target sub-bank SBNK_NTG by 'k'.

Referring further to FIG. 19, the host device 10 may need to transition the memory bank 140 into an idle state earlier than expected. For example, the host device 10 may need to activate another word line. In this case, the host device 10 may need to issue the precharge command PREC at a forty-eighth time point t48, which is earlier than the forty-sixth time point t46 of FIG. 18.

The host device 10 may issue a hidden refresh termination command QUIT_HR before issuing the precharge command PREC. For example, the host device 10 may issue the hidden refresh termination command QUIT_HR at the forty-seventh time point t47 between the forty-second time point t42 and the forty-third time point t43.

The memory device 100 may stop performing the additional hidden refresh operation based on the hidden refresh termination command QUIT_HR. That is, the memory device 100 may not perform a new hidden refresh operation after the hidden refresh termination command QUIT_HR is received. For example, the memory device 100 may not perform new hidden refresh operation after the hidden refresh operation between the forty-second time point t42 and the forty-third time point t43 is completed. In this case, the total number of hidden refresh operations performed based on the activation-hidden refresh repetition command HRR_ACT may be less than 'k' times.

In an embodiment, the memory device 100 may perform the hidden refresh operation that is not performed by the hidden refresh termination command QUIT_HR after entering an idle state. However, the scope of the disclosure is not limited thereto.

The host device 10 may issue the precharge command PREC after the hidden refresh operation is completed. For example, the host device 10 may issue the precharge command PREC after the hidden refresh consumption time tRFC_HR or more has elapsed since the hidden refresh termination command QUIT_HR was issued.

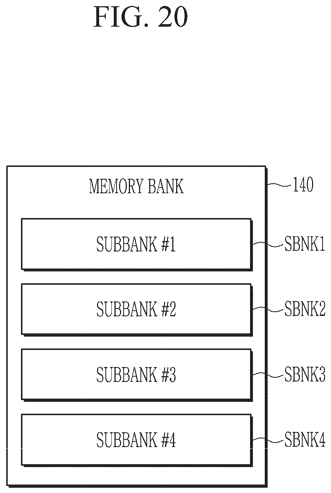

FIG. 20 is a block diagram showing a configuration of a memory bank according to an embodiment. Referring to FIG. 1 to FIG. 20, the memory bank 140 may further include four sub-banks SBNK. For example, the memory bank 140 may include the first sub-bank SBNK1, the second sub-bank SBNK2, a third sub-bank SBNK3 and a fourth sub-bank SBNK4. However, the scope of the disclosure is not limited thereto, and the memory bank 140 may include any number of sub-banks.

While the host device 10 controls the specific sub-bank SBNK, the memory device 100 may perform the hidden refresh operations on other sub-banks SBNK. In an example case in which the host device 10 issues the activation-hidden refresh command HR_ACT for the first sub-bank SBNK1, the memory device 100 may perform the hidden refresh operation for the second to fourth sub-banks SBNK2 to SBNK4. The method of performing the hidden refresh operation has been described previously with reference to FIG. 1 to FIG. 17, so the detailed description thereof is omitted.

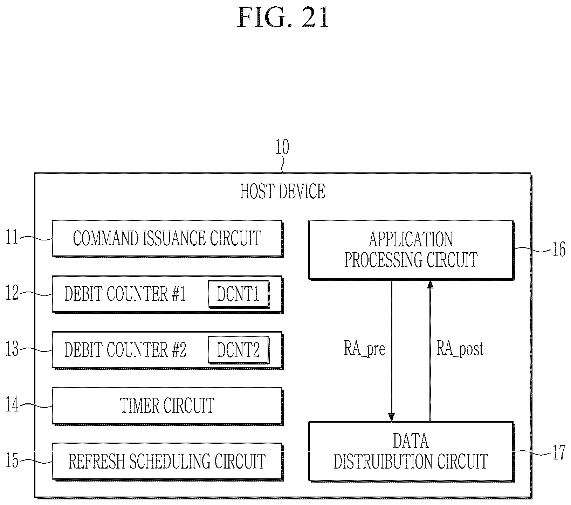

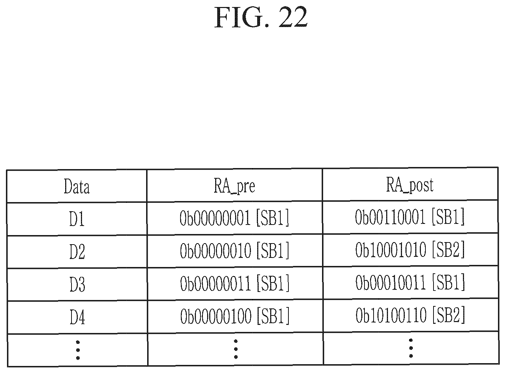

FIG. 21 and FIG. 22 are block diagrams showing a configuration of a host device according to an embodiment. Referring to FIG. 1 and FIG. 21, the host device 10 of FIG. 21 may further include an application processing circuit 16 and a data distribution circuit 17.

The application processing circuit 16 may perform various types of applications. For example, the application processing circuit 16 may execute various types of applications. The various types of applications may include, but is not limited to, an operating system, a firmware, and a user software. However, the scope of the disclosure is not limited to the types of applications that the application processing circuit 16 executes.

The application processing circuit 16 may store data used in executing the application in memory device 100. For example, by controlling other components of the host device 10, data DATA may be stored in the memory device 100 or data DATA stored in the memory device 100 may be read.

The application processing circuit 16 may determine a pre-shuffle row address RA_pre for specific data DATA to be stored. The application processing circuit 16 may provide the pre-shuffle row address RA_pre to a data distribution circuit 17.

The data distribution circuit 17 may transform the pre-shuffle row address RA_pre into a post-shuffle row address RA_post based on various types of shuffling algorithms. For example, the data distribution circuit 17 may perform various types of operations to transform the pre-shuffle row address RA_pre into the post-shuffle row address RA_post. The various types of operations may include, but is not limited to, an XOR operation, a rotation operation, etc. The data distribution circuit 17 may provide the post-shuffle row address RA_post to the application processing circuit 16.

The application processing circuit 16 may store data DATA in the memory bank 140 based on the post-shuffle row address RA_post. For example, the application processing circuit 16 may control a command issuance circuit 11 to issue an activation command ACT or the activation-hidden refresh command HR_ACT including the post-shuffle row address RA_post.

In this way, the application processing circuit 16 may generate the plurality of pre-shuffle row addresses RA_pre, respectively corresponding to the plurality of data DATA to be stored in the memory bank 140. The application processing circuit 16 may store the plurality of data DATA in the plurality of post-shuffle row addresses RA_post, respectively corresponding to the plurality of pre-shuffle row addresses RA_pre. In this case, the plurality of data DATA may be distributed and stored in multiple sub-banks SBNKs. In this case, a phenomenon of the hidden refresh not being performed for the specific sub-bank SBNK may be prevented. For example, the phenomenon of the hidden refresh not being performed for the specific sub-bank SBNK may be caused by the host device 10 repeatedly issuing the hidden refresh command HR only for a specific sub-bank SBNK.

For example, referring to FIG. 22, the application processing circuit 16 may determine to store a first data D1 to a fourth data D4 in the pre-shuffle row addresses RA_pre '0b00000001' to '0b00000100', respectively. That is, the application processing circuit 16 may determine to store the first data D1 to fourth data D4 in pre-shuffle row addresses RA_pre adjacent each other.

In an embodiment, the application processing circuit 16 may be implemented to store data DATA in the memory bank 140 based on the pre-shuffle row address RA_pre. For example, the application processing circuit 16 may control the command issuance circuit 11 to issue the activation command ACT or the activation-hidden refresh command HR_ACT including the pre-shuffle row address RA_pre. In this case, the first data D1 to the fourth data D4 may all be stored in the first sub-bank SBNK1. Therefore, in an example case in which the application processing circuit 16 reads the first data D1 to fourth data D4 from the memory bank 140, it may be difficult to perform the hidden refresh operation for the first sub-bank SBNK1. That is, in an example case in which the application processing circuit 16 stores the data DATA in the memory bank 140 based on the pre-shuffle row address RA_pre, the hidden refresh operation may be performed biasedly only for the specific sub-bank SBNK according to the data DATA access order of the application processing circuit 16.

The data distribution circuit 17 may convert the pre-shuffle row addresses RA_pre '0b00000001' to '0b00000100' to the post-shuffle row addresses RA_post '0b00110001', '0b10001010', '0b00010011', and '0b10100110', respectively. The data distribution circuit 17 may provide the post-shuffle row addresses RA_post '0b00110001', '0b10001010', '0b00010011', and '0b10100110' to the application processing circuit 16.

The application processing circuit 16 may determine to store the first data D1 to fourth data D4 in the post-shuffle row addresses RA_post '0b00110001', '0b10001010', '0b00010011', and '0b10100110', respectively. In this case, the first data D1 and the third data D3 may be stored in the first sub-bank SBNK1, and may second data D2 and the fourth data D4 may be stored in the second sub-bank SBNK2. Therefore, even in an example case in which the application processing circuit 16 reads the first data D1 to fourth data D4 from the memory bank 140, the hidden refresh operation for the first sub-bank SBNK1 and the second sub-bank SBNK2 may be performed evenly.

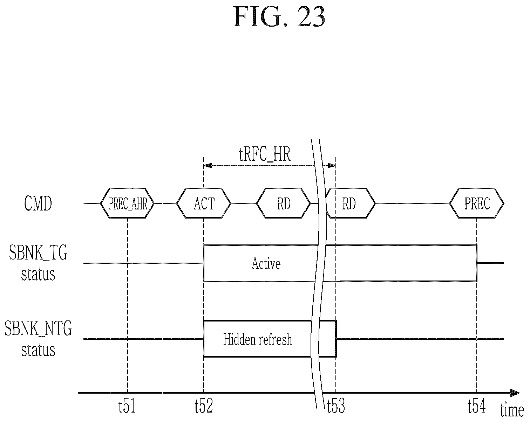

FIG. 23 is a timing diagram showing an implementation of a hidden refresh command according to an embodiment. The horizontal axis of FIG. 23 may represent a time.

Referring to FIG. 1 to FIG. 23, the host device 10 may issue an auto hidden refresh precharge command PREC_AHR at a fifty-first time point t51. After the auto hidden refresh precharge command PREC_AHR is received, the memory device 100 may process the activation command ACT as the activation-hidden refresh command HR_ACT until the precharge command PREC or the auto hidden refresh precharge command PREC_AHR for the same memory bank 140 is received. For example, the memory device 100 may receive the precharge command PREC at the fifty-fourth time point t54. In this case, the memory device 100 may process the activation command ACT received between the fifty-first time point t51 and the fifty-fourth time point t54 as the activation-hidden refresh command HR_ACT. That is, the hidden refresh command HR may be implemented as a combination of the auto hidden refresh precharge command PREC_AHR and the activation command ACT.

As a more detailed example, the host device 10 may issue the activation command ACT at a fifty-second time point t52. In this case, between the fifty-second time point t52 and a fifty-third time point t53, the memory device 100 may activate the target sub-bank SBNK_TG for the activation command ACT and perform the hidden refresh operation for the non-target sub-bank SBNK_NTG. In this case, the time interval between the fifty-second time point t52 and the fifty-third time point t53 may be the hidden refresh consumption time tRFC_HR.

In an embodiment, the auto hidden refresh precharge command PREC_AHR may be implemented as a precharge command including a flag bit indicating an auto hidden refresh. Therefore, according to the embodiment of FIG. 23, even in an example case in which the hidden refresh command HR is not separately defined between the host device 10 and the memory device 100, the host device 10 may be able to instruct the hidden refresh operation to the memory bank 140 based on the activation command ACT.

In an embodiment, the host device 10 may transmit a sub-bank identifier for the specific sub-bank SBNK to the memory device 100 along with the auto hidden refresh precharge command PREC_AHR. In this case, the memory device 100 may perform the hidden refresh operation only for sub-bank corresponding to the sub-bank identifier. However, the scope of the disclosure is not limited thereto.

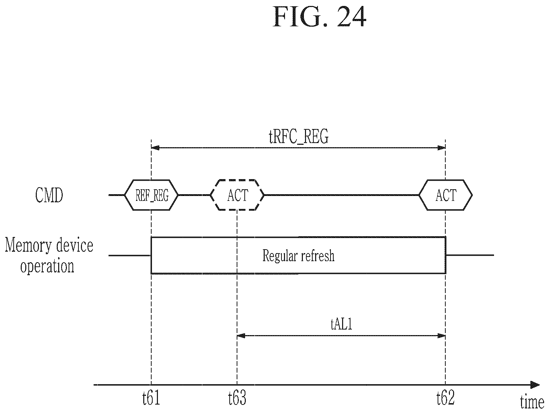

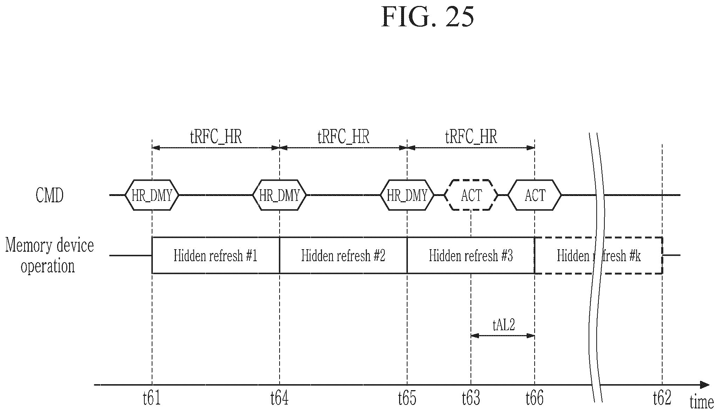

FIG. 24 and FIG. 25 are timing diagrams showing an operation method of a memory system according to an embodiment.

Referring to FIG. 24, in an example case in which the memory device 100 is in an idle state, the host device 10 may refresh the data stored in the memory bank 140 by issuing the regular refresh command REF_REG. For example, the host device 10 may issue the regular refresh command REF_REG at a sixty-first time point t61.

The memory device 100 may perform the regular refresh operation during the regular refresh consumption time tRFC_REG based on the regular refresh command REF_REG. For example, the memory device 100 may perform the regular refresh operation between the sixty-first time point t61 and the sixty-second time point t62.

Meanwhile, the host device 10 may need to access the memory bank 140 between the sixty-first time point t61 and the sixty-second time point t62. However, during the regular refresh consumption time tRFC_REG, the host device 10 may not allowed to issue the activation command ACT to the memory device 100. That is, even in an example case in which the host device 10 needs to access the memory device 100 at the sixty-third time point t63 between the sixty-first time point t61 and the sixty-second time point t62, issuing the activation command ACT of the host device 10 may be prohibited until the sixty-second time point t62.

The time interval of the sixty-third time point t63 and the sixty-second time point t62 may be referred to as a first activation delay time tAL1. That is, due to the regular refresh operation, the first activation delay time tAL1 may occur for the access to the memory device 100 of the host device 10.

On the other hand, referring further to FIG. 25, in an example case in which the memory device 100 is in an idle state, the host device 10 may refresh the data stored in the memory bank 140 by issuing a plurality of dummy hidden refresh commands HR_DMY. That is, instead of issuing the regular refresh command REF_REG at the sixty-first time point t61, the host device 10 may issue a plurality of dummy hidden refresh commands HR_DMY. That is, the host device 10 may issue the dummy hidden refresh command HR_DMY every hidden refresh consumption time tRFC_HR after the sixty-first time point t61 has elapsed. For example, the host device 10 may issue the dummy hidden refresh command HR_DMY at the sixty-first time point t61, the sixty-fourth time point t64, the sixty-fifth time point t65, and the sixty-sixth time point t66.

Each dummy hidden refresh command HR_DMY issued between the sixty-first time point t61 and the sixty-second time point t62 may correspond to the first sub-bank SBNK or the second sub-bank SBNK2. For example, the memory device 100 may refresh the first sub-bank SBNK1 based on the dummy hidden refresh command HR_DMY received at the sixty-first time point t61 and the sixty-fourth time point t64; and may refresh the second sub-bank SBNK2 based on the dummy hidden refresh command HR_DMY received at the sixty-fifth time point t65 and the sixty-sixth time point t66. However, the scope of the disclosure is not limited thereto.

In an embodiment, the dummy hidden refresh command HR_DMY may only represent the hidden refresh operation. For example, the memory device 100 may activate only one or more hidden refresh target word lines WL_TG_HR without activating the activation target word line WL_TG_ACT. In this case, the host device 10 may be able to issue the dummy hidden refresh command HR_DMY at a time interval shorter than the minimum activation period time tRCmin (e.g., the hidden refresh consumption time tRFC_HR). However, the scope of the disclosure is not limited to the configuration of the dummy hidden refresh command HR_DMY, and the specific operation method of the memory device 100 based on the dummy hidden refresh command HR_DMY.

The memory device 100 may perform the dummy hidden refresh operation based on the dummy hidden refresh command HR_DMY. For example, the memory device 100 may perform the first hidden refresh operation between the sixty-first time point t61 and the sixty-fourth time point t64; the second hidden refresh operation between the sixty-fourth time point t64 and the sixty-fifth time point t65; and the third hidden refresh operation between the sixty-fifth time point t65 and the sixty-sixth time point t66. In this way, the host device 10 may sequentially perform the first to k-th hidden refresh operation until the sixty-second time point t62.

Meanwhile, the host device 10 may need to access the memory bank 140 between the sixty-first time point t61 and the sixty-second time point t62. However, during the hidden refresh consumption time tRFC_HR, the host device 10 may not allowed to issue the activation command ACT to the memory device 100. Similarly to what was described with reference to FIG. 24 above, even in an example case in which the host device 10 needs to access the memory device 100 at the sixty-third time point t63, the issuing of the activation command ACT of the host device 10 may be prohibited until the sixty-sixth time point t66 in an example case in which the third hidden refresh operation is completed.

A time interval between the sixty-third time point t63 and the sixty-sixth time point t66 may be referred to as a second activation delay time tAL2. That is, due to the hidden refresh operation, the second activation delay time tAL2 may occur for the access to the memory device 100 of the host device 10.

The second activation delay time tAL2 may be shorter than the first activation delay time tAL1. That is, when the host device 10 controls the refresh operation for memory device 100 based on the hidden refresh command HR (e.g., a dummy hidden refresh command HR_DMY), the time that the host device 10 should wait to issue the activation command ACT may be reduced compared to when the host device 10 controls the refresh operation for the memory device 100 based on the regular refresh command REF_REG.

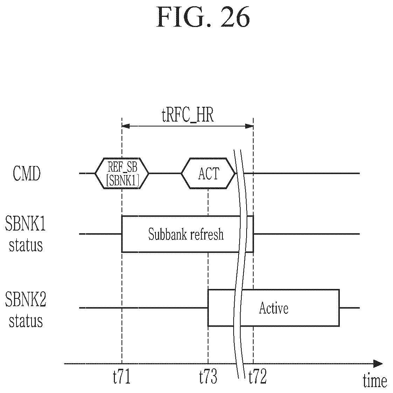

FIG. 26 is a timing diagram showing an operation of a memory system of FIG. 1 according to an embodiment. Referring to FIG. 1 FIG. 26, at a seventy-first time point t71, the host device 10 may issue a sub-bank refresh command REF_SB for the first sub-bank SBNK1.

In an embodiment, the host device 10 may provide the sub-bank identifier for one sub-bank to the memory device 100 along with the sub-bank refresh command REF_SB. The sub-bank identifier may be the address range identifier, as previously described with reference to in FIG. 6, but the disclosure is not limited thereto.

The memory device 100 may perform the sub-bank refresh operation for the first sub-bank SBNK1 based on the sub-bank refresh command REF_SB. For example, the memory device 100 may perform the sub-bank refresh operation for the first sub-bank SBNK1 from the seventy-first time point t71 to the seventy-second time point t72. In this case, the refresh manager 121 may increase the first hidden refresh count CNT_HR1 by '1'.

In an embodiment, the memory device 100 may perform the sub-bank refresh operation for one sub-bank SBNK in the manner similar to that described above referring to FIG. 8. In this case, the time interval between the seventy-first time point t71 and the seventy-second time point t72 may be equal to the hidden refresh consumption time tRFC_HR. However, the scope of the disclosure is not limited thereto. For example, the memory device 100 may perform the sub-bank refresh operation for one sub-bank SBNK in the manner similar to that described above referring to FIG. 17.

In an embodiment, based on that the host device 10 issuing the sub-bank refresh command REF_SB for the first sub-bank SBNK1, the second debit counter 13 may decrease the second debit count DCNT2 by a unit redemption cost.

Meanwhile, while the sub-bank refresh operation for the first sub-bank SBNK1 is performed, the host device 10 may access the second sub-bank SBNK2. For example, the host device 10 may issue the activation command ACT for second sub-bank SBNK2 at the seventy-third time point t73 between the seventy-first time point t71 and the seventy-second time point t72. In more detail, the host device 10 may issue the activation command ACT with a row address corresponding to one of the second word line groups WLG2 at the seventy-third time point t73. In this case, the memory device 100 may be able to activate the second sub-bank SBNK2 based on the activation command ACT.

## Claims

1. A host device (10) comprising:
a command issuance circuit (11) configured to issue a regular refresh command (REF_REG) for a memory bank (140) of a memory device (100) at every regular refresh period (tREFI_REG);
a first debit counter (12) configured to manage a first debit count (DCNT1) for a first sub-bank (SBNK1) in the memory bank (140);
a second debit counter (13) configured to manage a second debit count (DCNT2) for a second sub-bank (SBNK2) in the memory bank (140); and
a refresh scheduling circuit (15) configured to determine whether to skip issuing the regular refresh command (REF_REG) of the command issuance circuit (11) based on the first debit count (DCNT1) and the second debit count (DCNT2).

2. The host device (10) of claim 1, wherein:
the command issuance circuit (11) is further configured to issue a first hidden refresh command for the first sub-bank (SBNK1) or a second hidden refresh command for the second sub-bank (SBNK2),
the first debit counter (12) is configured to decrease the first debit count (DCNT1) based on the command issuance circuit (11) issuing the second hidden refresh command, and
the second debit counter (13) is configured to decrease the second debit count (DCNT2) based on the command issuance circuit (11) issuing the first hidden refresh command.

3. The host device (10) of claim 2, wherein:
the first hidden refresh command corresponds to a first row address in a first row address range for the first sub-bank (SBNK1), and
the second hidden refresh command corresponds to a second row address in a second row address range for the second sub-bank (SBNK2).

4. The host device (10) of claim 2 or 3, wherein:
the first debit counter (12) is further configured to increase the first debit count (DCNT1) at every regular refresh period (tREFI_REG);, and
the second debit counter (13) is further configured to increase the second debit count (DCNT2) at every regular refresh period (tREFI_REG);.

5. The host device (10) of claim 4, wherein the first debit counter (12) is further configured to:
decrease the first debit count (DCNT1) by a first unit redemption cost based on that the command issuance circuit (11) issuing the second hidden refresh command, and
increase the first debit count (DCNT1) by a first skip cost greater than the first unit redemption cost at every regular refresh period (tREFI_REG);,
the second debit counter (13) is further configured to:
decrease the second debit count (DCNT2) by a second unit redemption cost based on that the command issuance circuit (11) issuing the first hidden refresh command, and
increase the second debit count (DCNT2) by a second skip cost greater than the second unit redemption cost at every regular refresh period (tREFI_REG);.

6. The host device (10) of claim 5, wherein:
the first debit counter (12) is further configured to decrease the first debit count (DCNT1) by the first skip cost based on the command issuance circuit (11) issuing the regular refresh command, and
the second debit counter (13) is further configured to decrease the second debit count (DCNT2) by the second skip cost based on the command issuance circuit (11) issuing the regular refresh command.

7. The host device (10) of any one of claims 2 to 6, wherein the first hidden refresh command comprises:
a precharge command (PREC) comprising an auto hidden refresh bit; and
an activation command (ACT), which is issued after the precharge command (PREC), for the first sub-bank (SBNK1).

8. The host device (10) of any one of claims 1 to 7, wherein the refresh scheduling circuit (15) is further configured to determine whether to skip issuing the regular refresh command (REF_REG) in order to maintain the first debit count (DCNT1) and second debit count (DCNT2) to be within a debit count range.

9. The host device (10) of any one of claims 1 to 8, wherein, based on the memory bank (140) being idle, the command issuance circuit (11) is further configured to:
perform a refresh operation for the memory bank (140), by issuing a first plurality of dummy hidden refresh commands for the first sub-bank (SBNK1) and a second plurality of dummy hidden refresh commands for the second sub-bank (SBNK2).

10. The host device (10) of any one of claims 1 to 9, further comprising:
a third debit counter configured to manage a third debit count for a third sub-bank in the memory bank (140); and
a fourth debit counter configured to manage a fourth debit count for a fourth sub-bank in the memory bank (140),
wherein the refresh scheduling circuit (15) is configured to determine whether to skip issuing the regular refresh command (REF_REG) for the memory bank (140) based on the first to fourth debit counts.

11. A memory device (100) comprising:
a memory bank (140) comprising a first sub-bank (SBNK1) and a second sub-bank (SBNK2);
a row decoder (130) comprising a first sub-row decoder (SDEC1) connected to the first sub-bank (SBNK1), and a second sub-row decoder (SDEC2) connected to the second sub-bank (SBNK2); and
a control logic circuit (120) configured to perform, based on a first hidden refresh command corresponding to a first row address of the first sub-bank (SBNK1), a hidden refresh operation for the second sub-bank (SBNK2) within a time period by controlling the second sub-row decoder (SDEC2),
wherein a length of the time period is shorter than a minimum activation period (tRCmin) for the memory bank (140).

12. The memory device (100) of claim 11, wherein:
the first sub-row decoder (SDEC1) is connected to the first sub-bank (SBNK1) through a first word line group (WLG1),
the second sub-row decoder (SDEC2) is connected to the second sub-bank (SBNK2) through a second word line group (WLG2),
each first word line in the first word line group (WLG1) corresponds to a row address whose most significant bit is a first value, and
each second word line in the second word line group (WLG2) corresponds to a row address whose most significant bit is a second value.

13. The memory device (100) of claim 12, wherein based on the first hidden refresh command, the control logic circuit (120) is further configured to:
activate an activation target word line in the first word line group (WLG1) by controlling the first sub-row decoder (SDEC1); and
activate one or more hidden refresh target word lines in the second word line group (WLG2) by controlling the second sub-row decoder (SDEC2).

14. The memory device (100) of claim 13, wherein the control logic circuit (120) comprises:
a refresh manager (121) configured to determine the one or more hidden refresh target word lines, based on a first count indicating a number of times a regular refresh has been performed for the memory bank (140) and a second count indicating a number of times that the hidden refresh has been performed for the second sub-bank (SBNK2).

15. The memory device (100) of claim 13 or 14, wherein the second sub-row decoder (SDEC2) is further configured to maintain the one or more hidden refresh target word lines activated during the time period based on control of the control logic circuit (120).
